# EUROPEAN PATENT APPLICATION

(11) **EP 4 712 141 A1**
(43) Date of publication of application: **18.03.2026**
(21) Application number: 24803428.2
(22) Date of filing: 01.05.2024
(51) Int. Cl.: H01L 27/146

(54) **SEMICONDUCTOR DEVICE**

(30) Priority: 10.05.2023 JP 2023078072
(71) Applicant: Sony Semiconductor Solutions Corporation, Atsugi-shi, Kanagawa 243-0014 (JP)
(72) Inventor: IIJIMA, Tadashi, Atsugi-shi, Kanagawa 243-0014 (JP); KANDA, Masao, Atsugi-shi, Kanagawa 243-0014 (JP); NAKAMURA, Yusuke, Atsugi-shi, Kanagawa 243-0014 (JP); TOMITA, Ken, Atsugi-shi, Kanagawa 243-0014 (JP); MIZUTA, Kyohei, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/016746
(87) International publication number: WO 2024/232316

(57) **Abstract**

The present disclosure improves light detection characteristics of a semiconductor device. A semiconductor device includes a charge transfer section. The charge transfer section includes a MOS transistor including a first semiconductor region disposed in a semiconductor substrate, a second semiconductor region disposed in the vicinity of a front surface of the semiconductor substrate, and a plurality of vertical gates, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other. The plurality of vertical gates are disposed in parallel.

## Description

### Technical Field

The present disclosure relates to a semiconductor device.

### Background Art

In a semiconductor device such as an imaging element, a photoelectric conversion section disposed in a pixel generates a charge in accordance with incident light during an exposure period, and a charge transfer section transfers the generated charge to a charge holding section after the exposure period elapses. Subsequently, an image signal is generated by a circuit disposed in the pixel on the basis of the charge held in the charge holding section. In such an imaging element, an imaging element in which the photoelectric conversion section is disposed on a back surface side of a semiconductor substrate is used. In this imaging element, a charge transfer section that transfers the charge generated by the photoelectric conversion section to the charge holding section disposed on a front surface side of the semiconductor substrate is used. For example, a solid-state imaging device including a charge transfer section constituted of a transfer transistor including two vertical gate electrodes embedded in a front surface of a semiconductor substrate has been proposed (refer to PTL 1, for example).

### Citation List

### Patent Literature

PTL 1: JP 2010-114273 A

### Summary

### Technical Problem

To meet demands for higher image definition, the miniaturization of pixel size in imaging elements is being advanced. In this pixel having a reduced size, an imaging element is used in which a potential of the photoelectric conversion section of the pixel is deepened to improve a holding capacity of the charge. In such an imaging element, there is a problem in that it is difficult for the charge transfer section to transfer the charge from the photoelectric conversion section, impairing light detection characteristics.

Thus, the present disclosure proposes a semiconductor device having improved light detection characteristics.

### Solution to Problem

A semiconductor device according to a first aspect of the present disclosure includes a charge transfer section including a MOS transistor including a first semiconductor region disposed in a semiconductor substrate, a second semiconductor region disposed in the vicinity of a front surface of the semiconductor substrate, and a plurality of vertical gates, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other. The plurality of vertical gates are disposed in parallel.

A semiconductor device according to a second aspect of the present disclosure includes a charge transfer section including a MOS transistor including a first semiconductor region disposed in a semiconductor substrate, a second semiconductor region disposed in the vicinity of a front surface of the semiconductor substrate, and a first vertical gate, a second vertical gate, and a third vertical gate, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other. The first vertical gate and the second vertical gate are disposed between the second semiconductor region and the third vertical gate in a plan view.

A semiconductor device according to a third aspect of the present disclosure includes a charge transfer section including a MOS transistor including a first semiconductor region disposed in a semiconductor substrate, a second semiconductor region disposed in the vicinity of a front surface of the semiconductor substrate, and a plurality of vertical gates, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other. The plurality of vertical gates are configured to have different sizes.

A semiconductor device according to a fourth aspect of the present disclosure includes a pixel including a charge transfer section including a MOS transistor including a first semiconductor region disposed in a semiconductor substrate, a second semiconductor region disposed in the vicinity of a front surface of the semiconductor substrate, and a vertical gate, the vertical gate being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other; and a separation section. The vertical gate includes a side surface in contact with a surface of a semiconductor region having the same orientation plane as an orientation plane of a surface of the semiconductor region in contact with the separation section.

### Brief Description of Drawings

[Fig. 1]

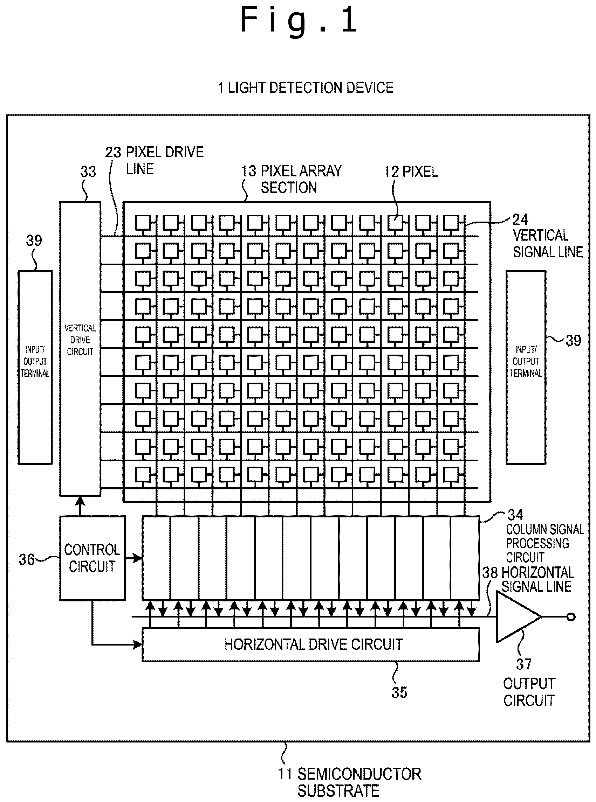

   Fig. 1 is a diagram depicting an example of a schematic configuration of a light detection device according to an embodiment of the present disclosure.
[Fig. 2]

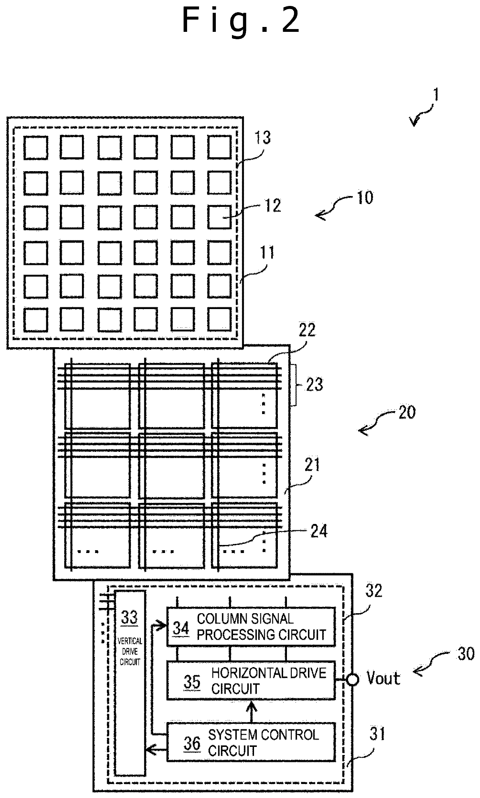

   Fig. 2 is a diagram depicting another example of a schematic configuration of the light detection device according to an embodiment of the present disclosure.
[Fig. 3]

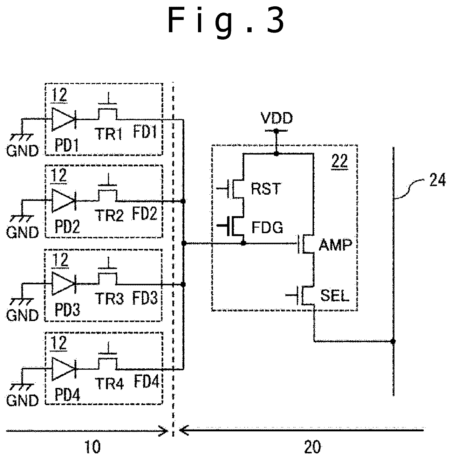

   Fig. 3 is a diagram depicting a configuration example of pixels according to an embodiment of the present disclosure.
[Fig. 4]

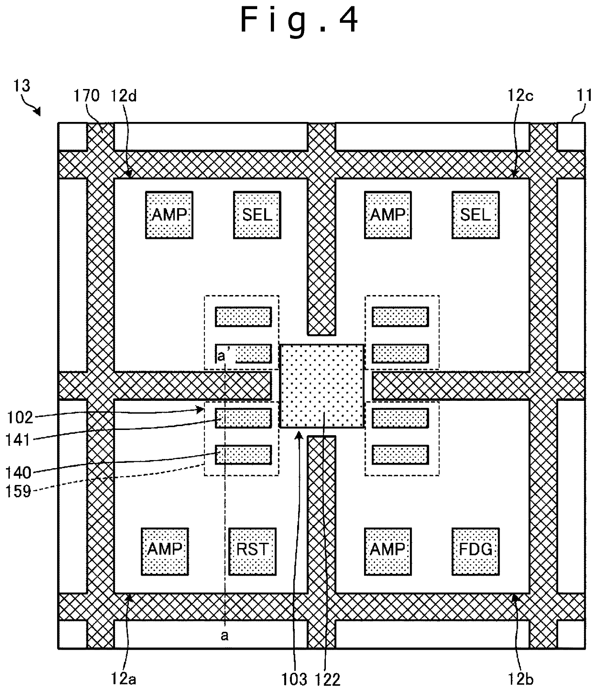

   Fig. 4 is a diagram depicting a configuration example of the pixels according to a first embodiment of the present disclosure.
[Fig. 5]

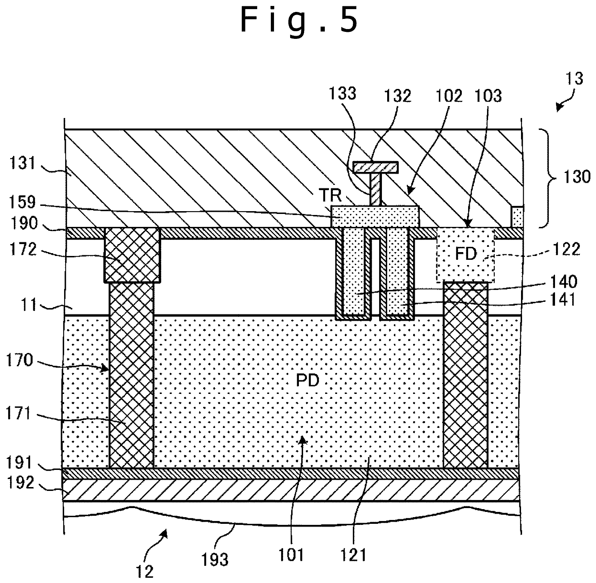

   Fig. 5 is a diagram depicting a configuration example of the pixels according to the first embodiment of the present disclosure.
[Fig. 6A]

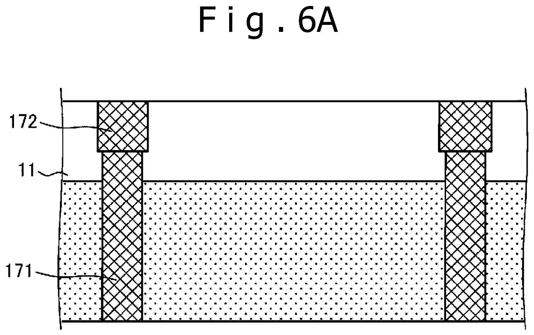

   Fig. 6A is a diagram depicting an example of a manufacturing method of the light detection device according to the first embodiment of the present disclosure.
[Fig. 6B]

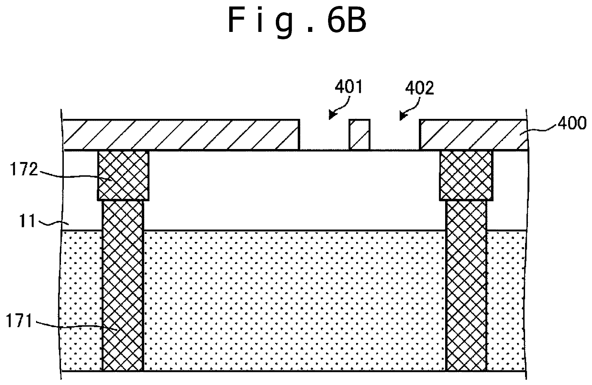

   Fig. 6B is a diagram depicting an example of the manufacturing method of the light detection device according to the first embodiment of the present disclosure.
[Fig. 6C]

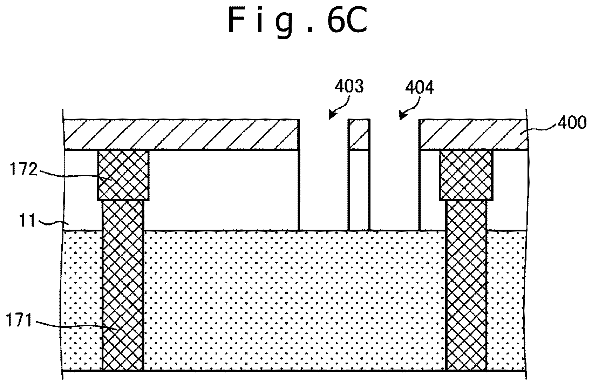

   Fig. 6C is a diagram depicting an example of the manufacturing method of the light detection device according to the first embodiment of the present disclosure.
[Fig. 6D]

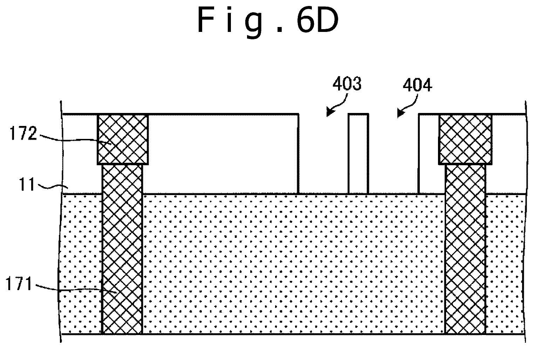

   Fig. 6D is a diagram depicting an example of the manufacturing method of the light detection device according to the first embodiment of the present disclosure.
[Fig. 6E]

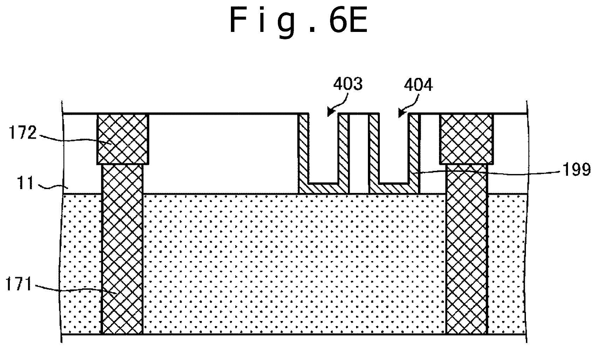

   Fig. 6E is a diagram depicting an example of the manufacturing method of the light detection device according to the first embodiment of the present disclosure.
[Fig. 6F]

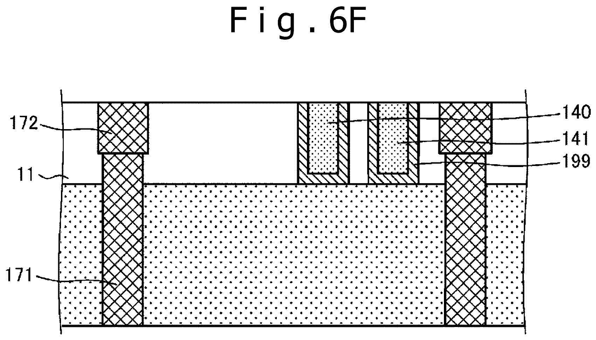

   Fig. 6F is a diagram depicting an example of the manufacturing method of the light detection device according to the first embodiment of the present disclosure.
[Fig. 7]

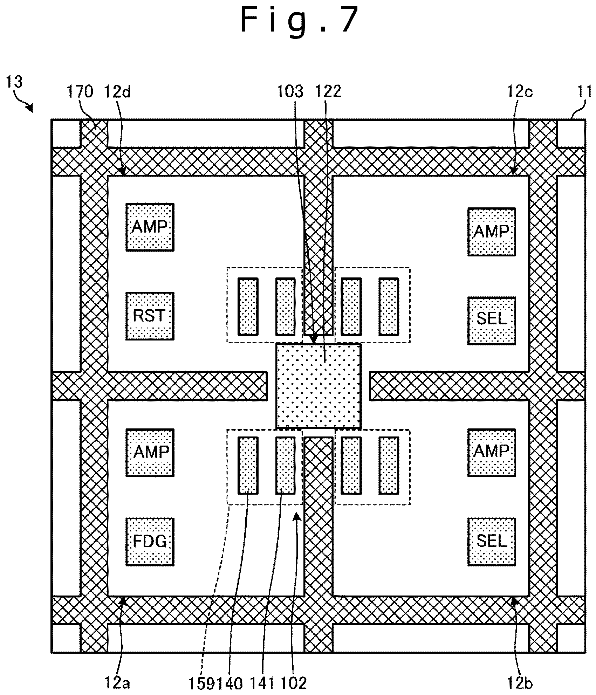

   Fig. 7 is a diagram depicting a configuration example of the pixels according to a second embodiment of the present disclosure.
[Fig. 8]

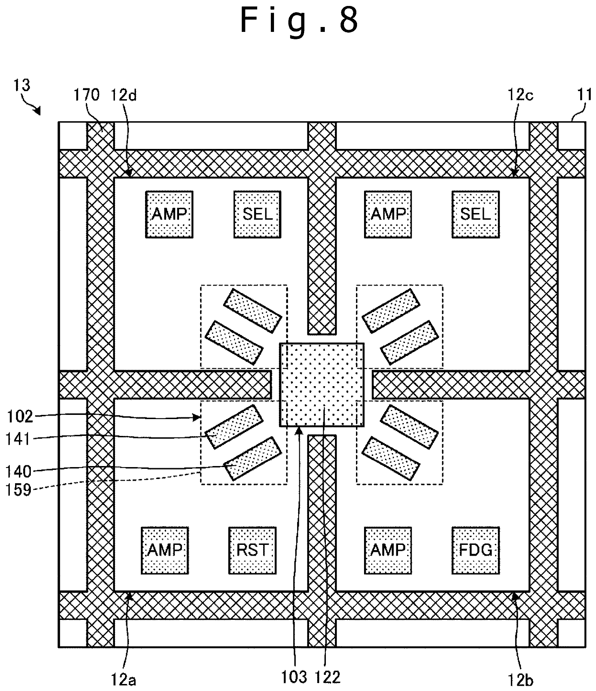

   Fig. 8 is a diagram depicting a configuration example of the pixels according to the second embodiment of the present disclosure.
[Fig. 9]

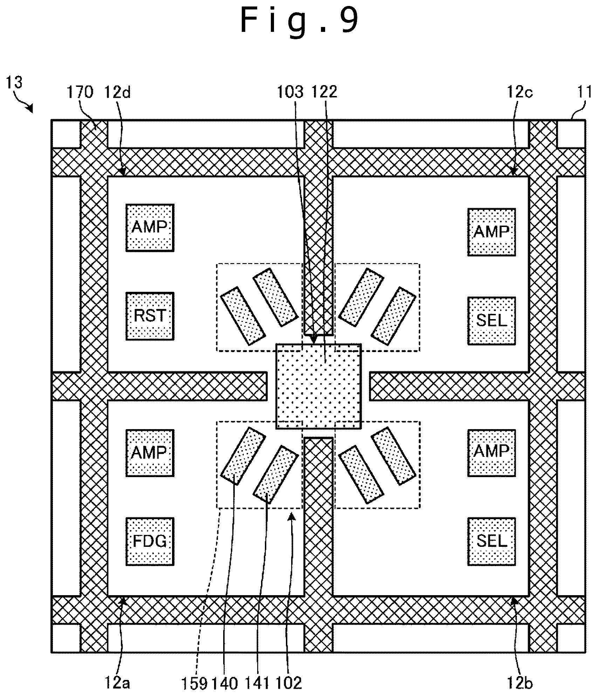

   Fig. 9 is a diagram depicting a configuration example of the pixels according to the second embodiment of the present disclosure.
[Fig. 10]

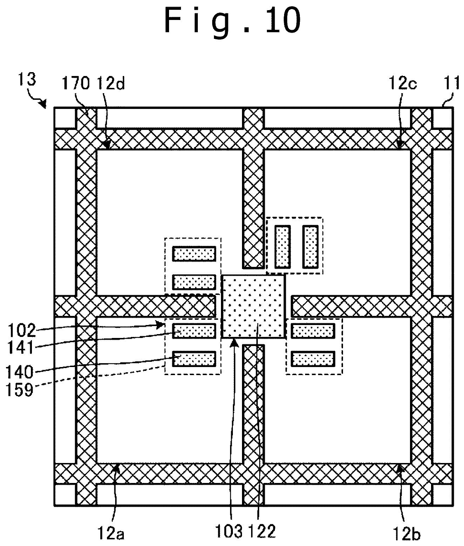

   Fig. 10 is a diagram depicting a configuration example of the pixels according to the second embodiment of the present disclosure.
[Fig. 11]

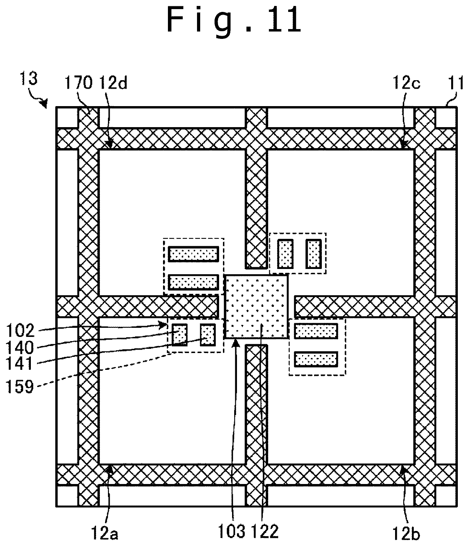

   Fig. 11 is a diagram depicting a configuration example of the pixels according to the second embodiment of the present disclosure.
[Fig. 12]

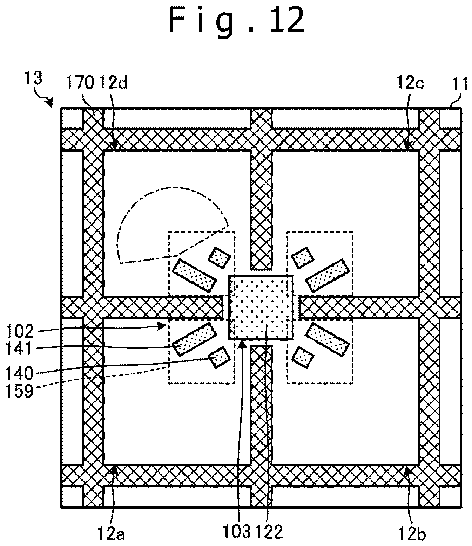

   Fig. 12 is a diagram depicting a configuration example of the pixels according to the second embodiment of the present disclosure.
[Fig. 13]

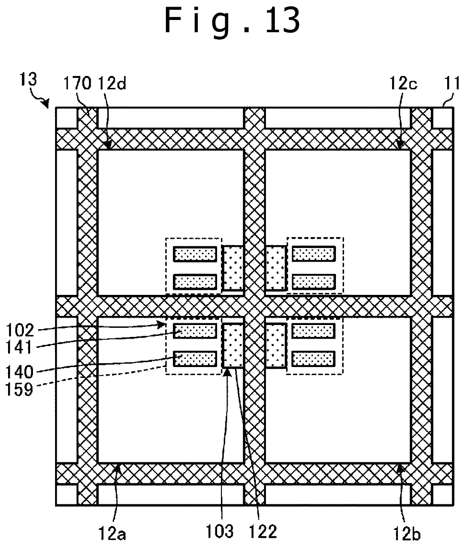

   Fig. 13 is a diagram depicting a configuration example of the pixels according to the second embodiment of the present disclosure.
[Fig. 14]

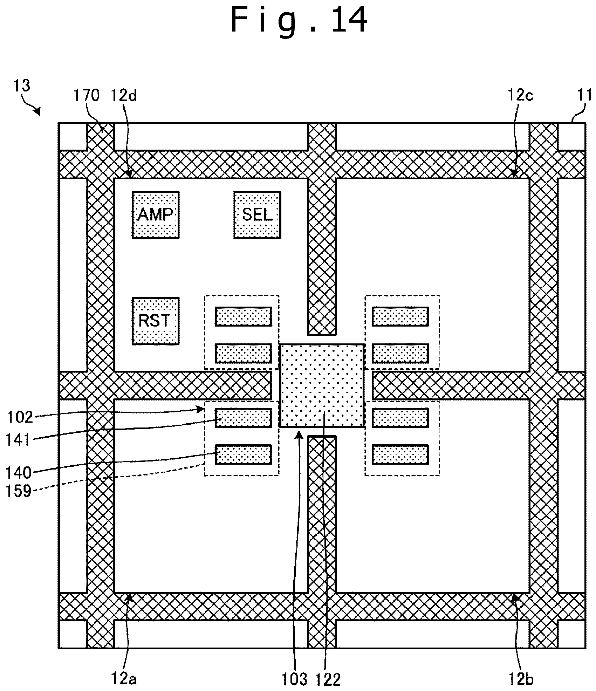

   Fig. 14 is a diagram depicting a configuration example of the pixels according to the second embodiment of the present disclosure.
[Fig. 15]

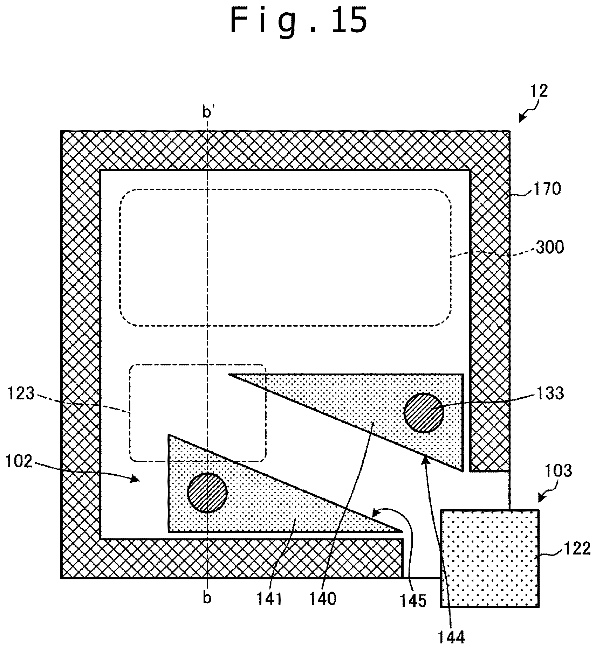

   Fig. 15 is a diagram depicting a configuration example of the pixel according to a third embodiment of the present disclosure.
[Fig. 16]

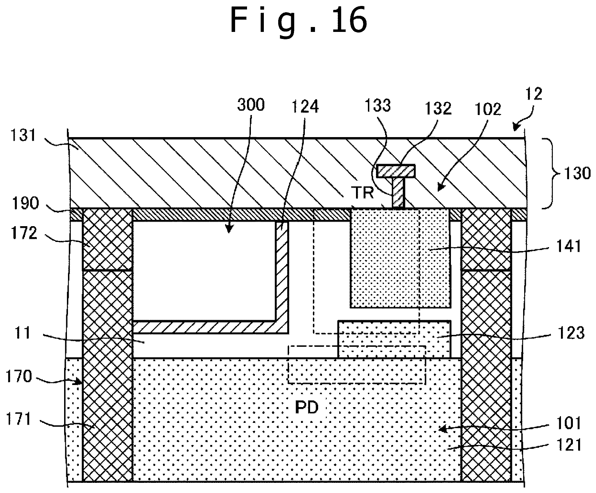

   Fig. 16 is a diagram depicting a configuration example of the pixel according to the third embodiment of the present disclosure.
[Fig. 17]

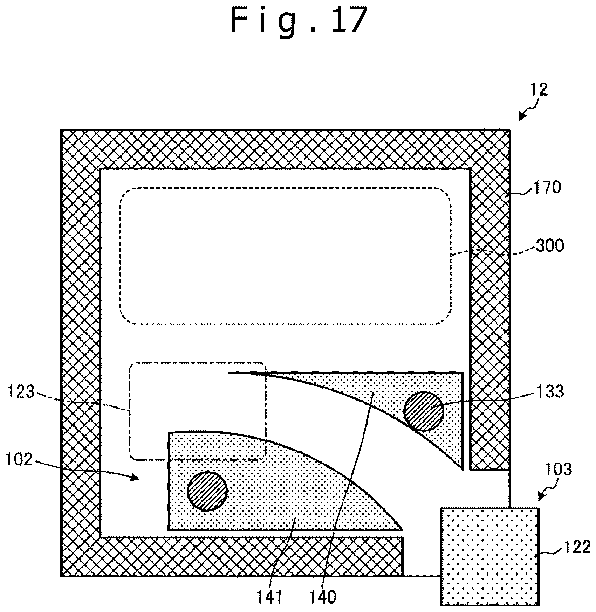

   Fig. 17 is a diagram depicting another configuration example of the pixel according to the third embodiment of the present disclosure.
[Fig. 18]

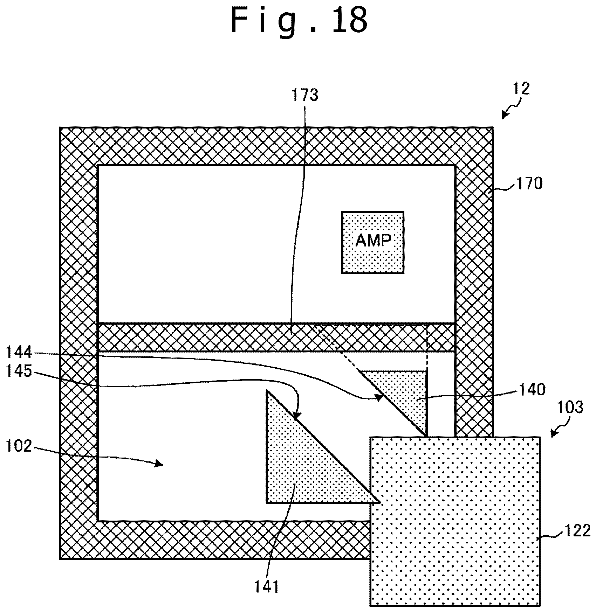

   Fig. 18 is a diagram depicting a configuration example of the pixel according to a fourth embodiment of the present disclosure.
[Fig. 19]

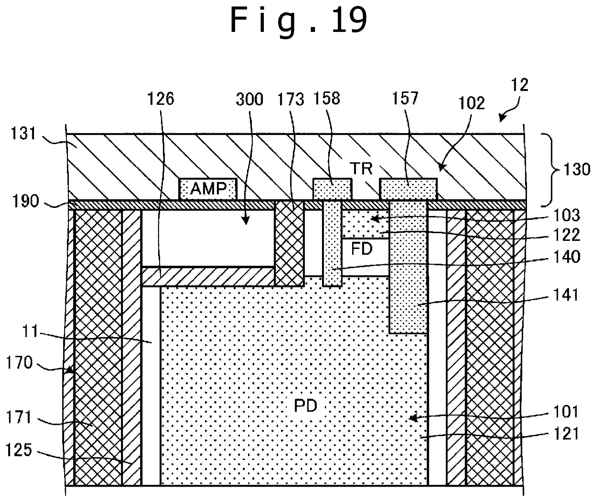

   Fig. 19 is a diagram depicting a configuration example of the pixel according to the fourth embodiment of the present disclosure.
[Fig. 20]

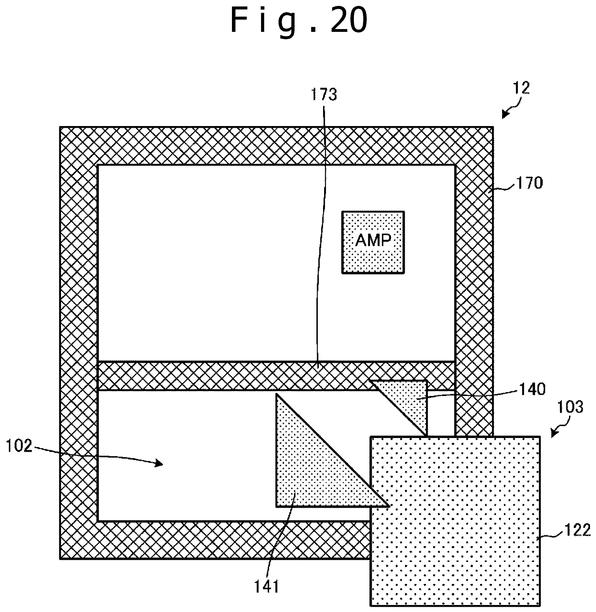

   Fig. 20 is a diagram depicting another configuration example of the pixel according to the fourth embodiment of the present disclosure.
[Fig. 21]

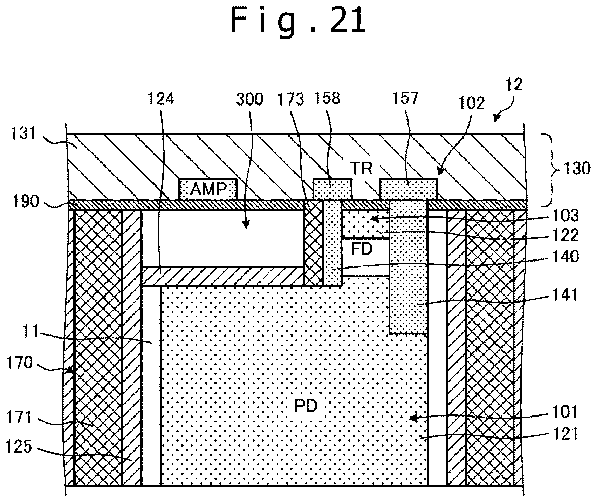

   Fig. 21 is a diagram depicting another configuration example of the pixel according to the fourth embodiment of the present disclosure.
[Fig. 22]

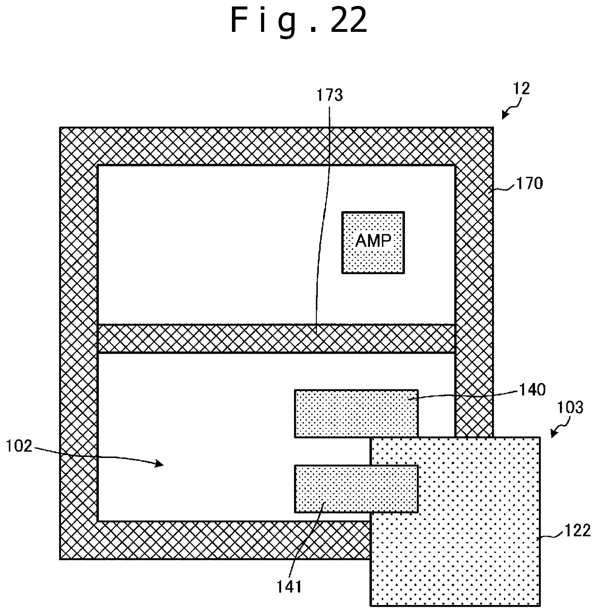

   Fig. 22 is a diagram depicting another configuration example of the pixel according to the fourth embodiment of the present disclosure.
[Fig. 23]

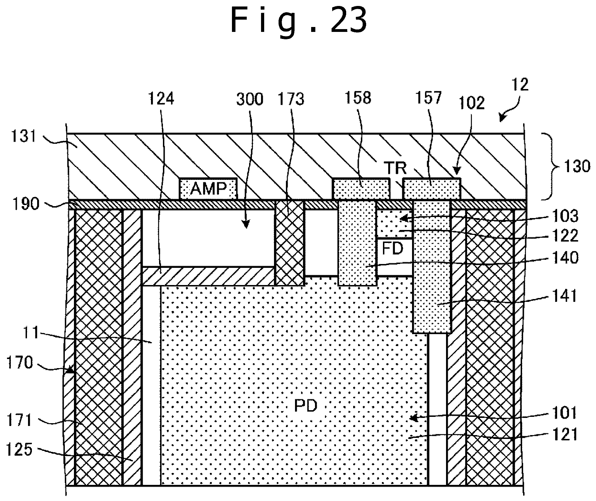

   Fig. 23 is a diagram depicting another configuration example of the pixel according to the fourth embodiment of the present disclosure.
[Fig. 24]

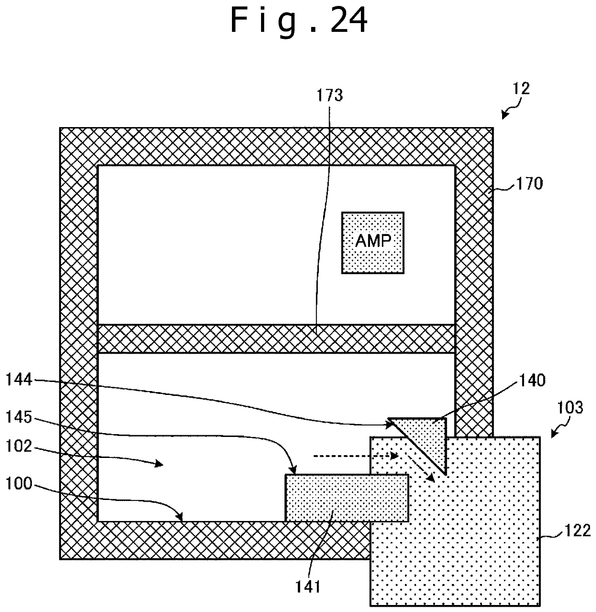

   Fig. 24 is a diagram depicting another configuration example of the pixel according to a modification of the fourth embodiment of the present disclosure.
[Fig. 25]

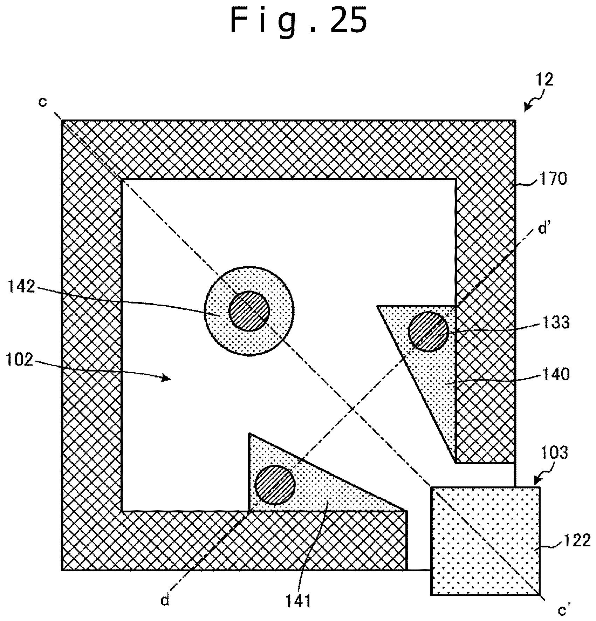

   Fig. 25 is a diagram depicting a configuration example of the pixel according to a fifth embodiment of the present disclosure.
[Fig. 26A]

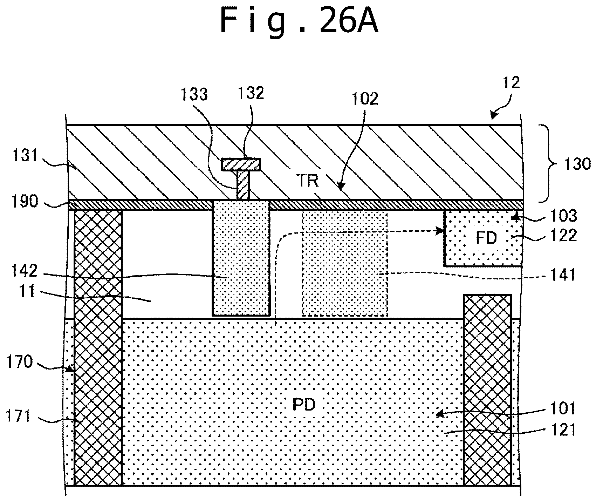

   Fig. 26A is a diagram depicting a configuration example of the pixel according to the fifth embodiment of the present disclosure.
[Fig. 26B]

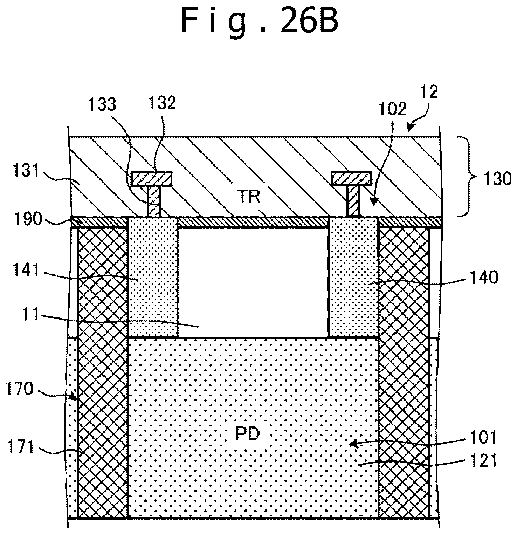

   Fig. 26B is a diagram depicting a configuration example of the pixel according to the fifth embodiment of the present disclosure.
[Fig. 27]

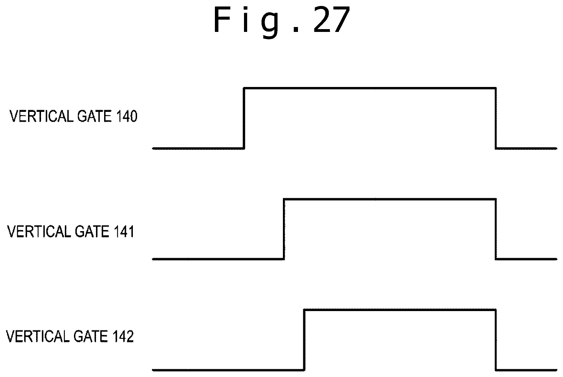

   Fig. 27 is a diagram depicting an example of the driving of a charge transfer section according to the fifth embodiment of the present disclosure.
[Fig. 28]

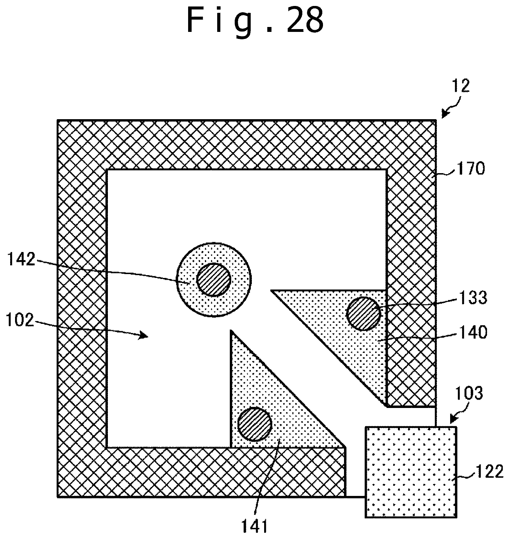

   Fig. 28 is a diagram depicting a configuration example of the pixel according to a sixth embodiment of the present disclosure.
[Fig. 29]

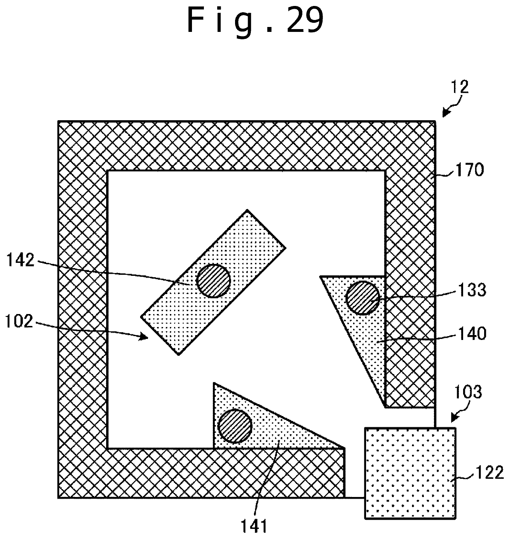

   Fig. 29 is a diagram depicting a configuration example of the pixel according to the sixth embodiment of the present disclosure.
[Fig. 30]

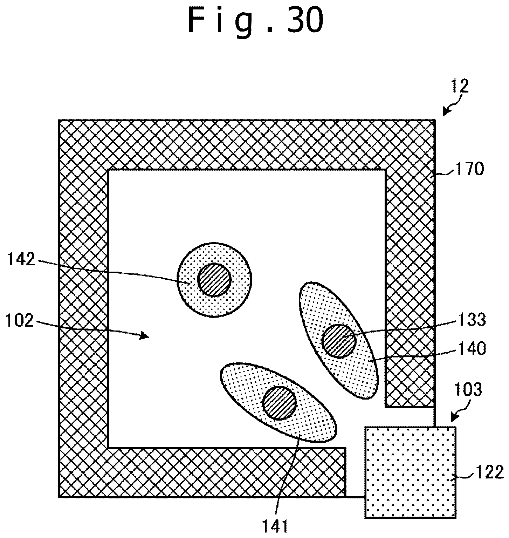

   Fig. 30 is a diagram depicting a configuration example of the pixel according to the sixth embodiment of the present disclosure.
[Fig. 31]

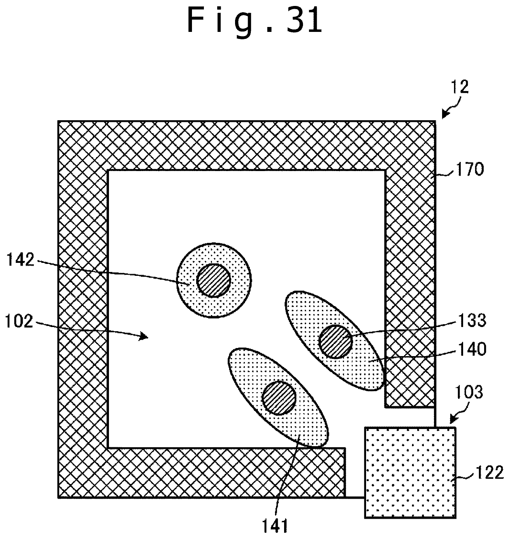

   Fig. 31 is a diagram depicting a configuration example of the pixel according to the sixth embodiment of the present disclosure.
[Fig. 32]

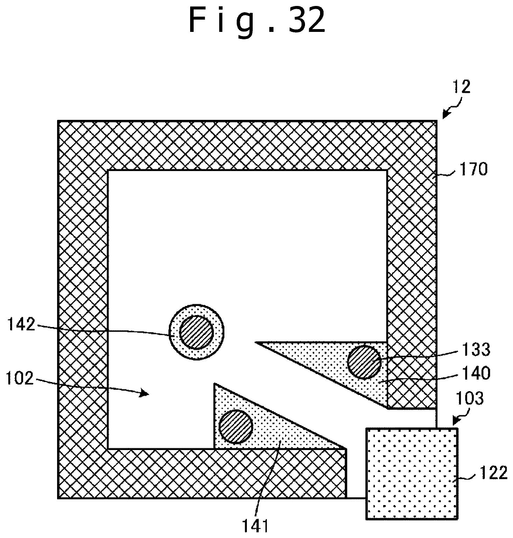

   Fig. 32 is a diagram depicting a configuration example of the pixel according to the sixth embodiment of the present disclosure.
[Fig. 33]

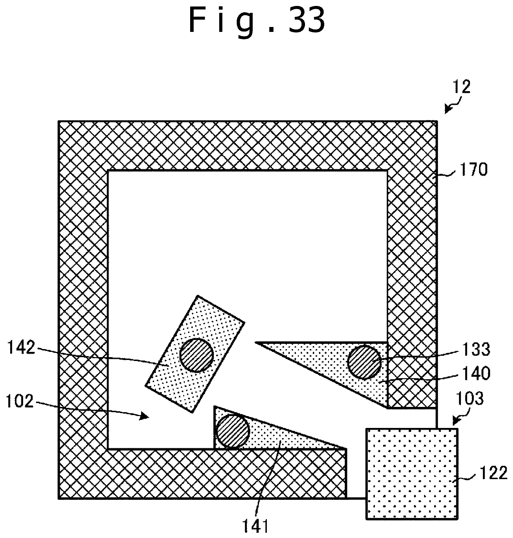

   Fig. 33 is a diagram depicting a configuration example of the pixel according to the sixth embodiment of the present disclosure.
[Fig. 34]

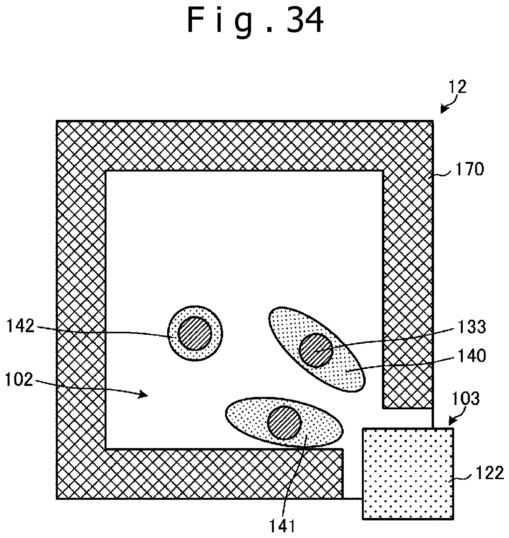

   Fig. 34 is a diagram depicting a configuration example of the pixel according to the sixth embodiment of the present disclosure.
[Fig. 35]

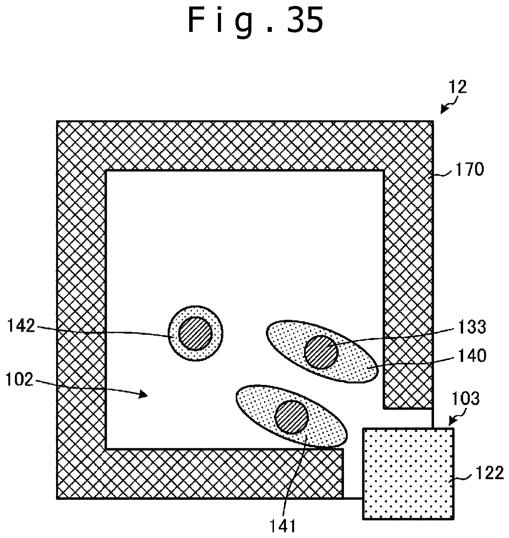

   Fig. 35 is a diagram depicting a configuration example of the pixel according to the sixth embodiment of the present disclosure.
[Fig. 36]

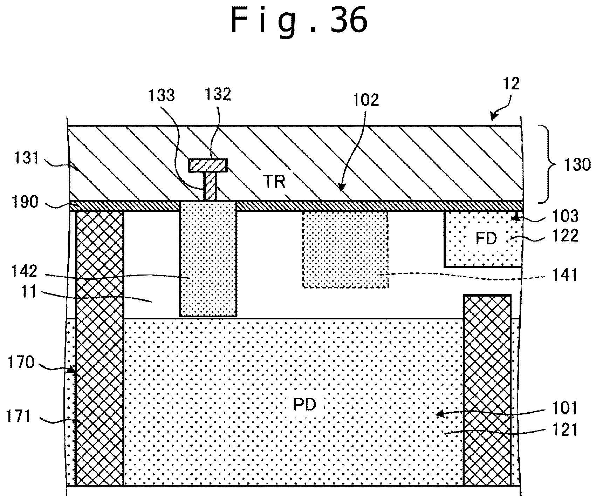

   Fig. 36 is a diagram depicting another configuration example of the pixel according to the sixth embodiment of the present disclosure.
[Fig. 37]

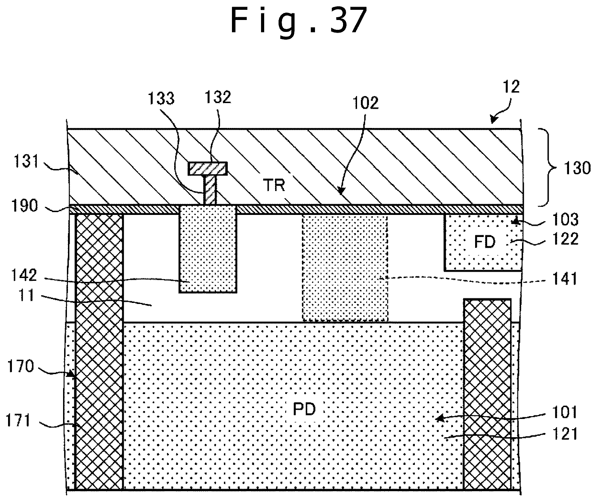

   Fig. 37 is a diagram depicting another configuration example of the pixel according to the sixth embodiment of the present disclosure.
[Fig. 38]

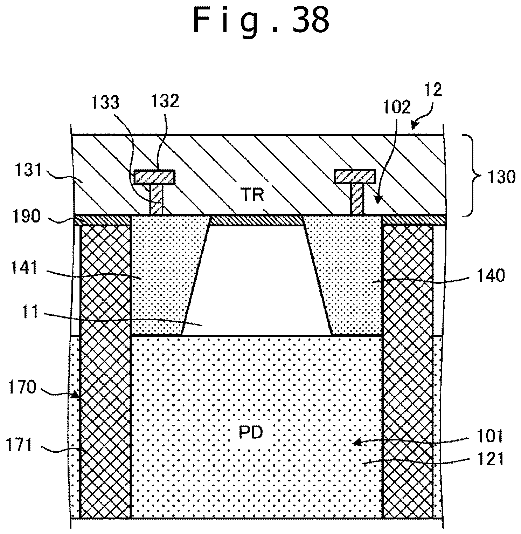

   Fig. 38 is a diagram depicting another configuration example of the pixel according to the sixth embodiment of the present disclosure.
[Fig. 39]

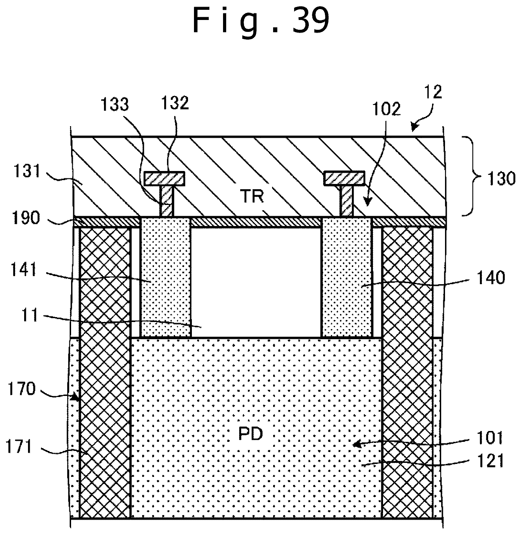

   Fig. 39 is a diagram depicting another configuration example of the pixel according to the sixth embodiment of the present disclosure.
[Fig. 40]

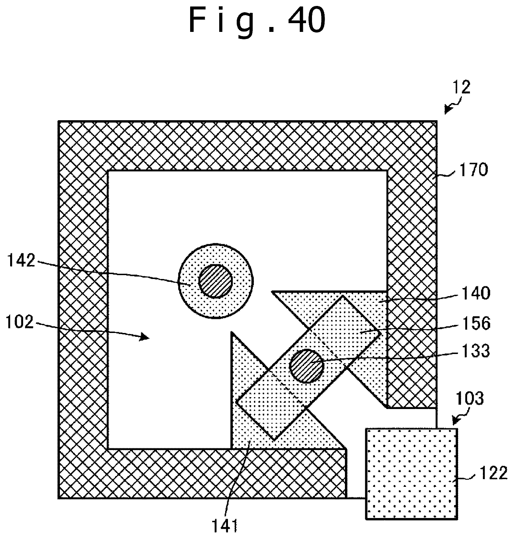

   Fig. 40 is a diagram depicting another configuration example of the pixel according to the sixth embodiment of the present disclosure.
[Fig. 41]

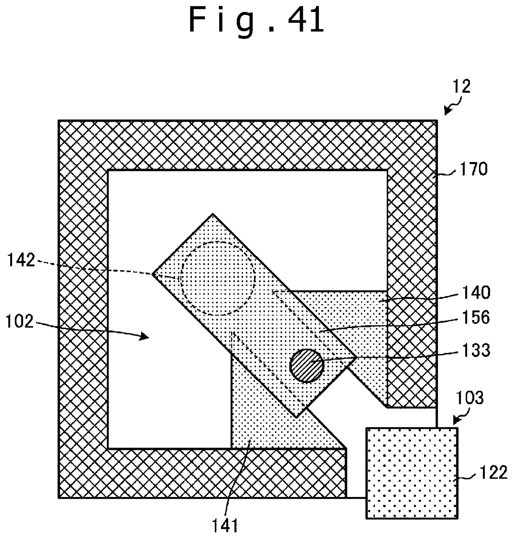

   Fig. 41 is a diagram depicting another configuration example of the pixel according to the sixth embodiment of the present disclosure.
[Fig. 42]

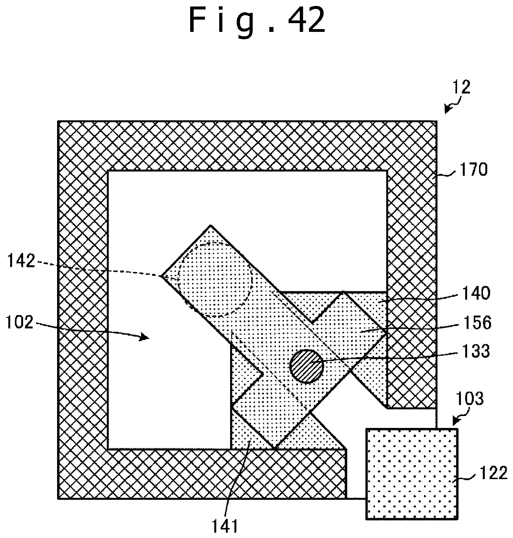

   Fig. 42 is a diagram depicting another configuration example of the pixel according to the sixth embodiment of the present disclosure.
[Fig. 43]

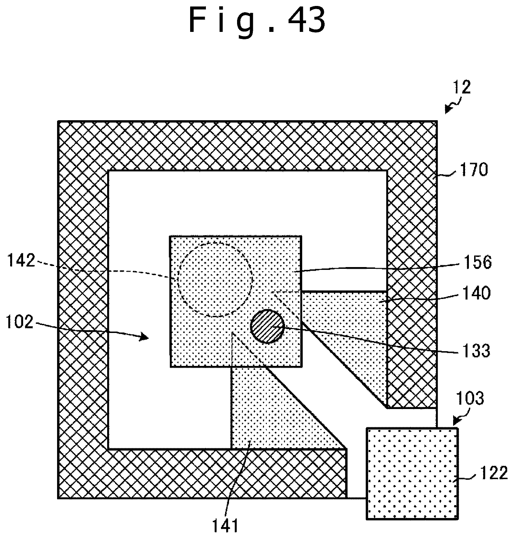

   Fig. 43 is a diagram depicting another configuration example of the pixel according to the sixth embodiment of the present disclosure.
[Fig. 44]

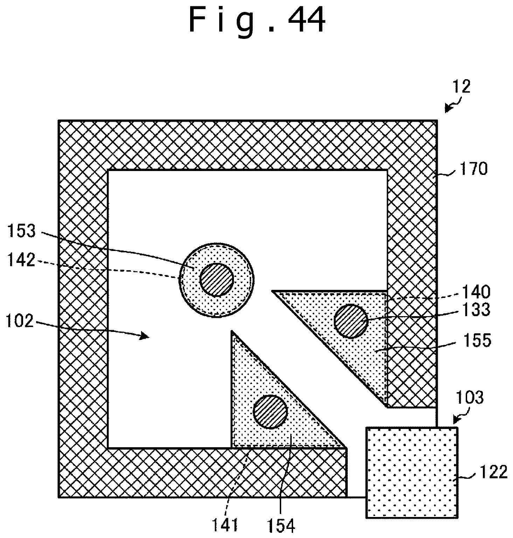

   Fig. 44 is a diagram depicting another configuration example of the pixel according to the sixth embodiment of the present disclosure.
[Fig. 45]

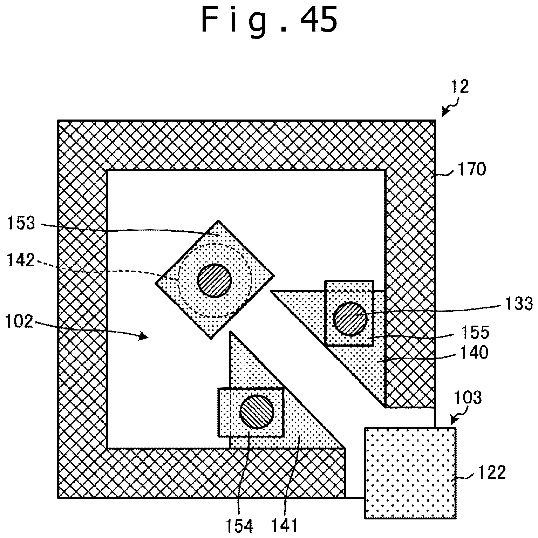

   Fig. 45 is a diagram depicting another configuration example of the pixel according to the sixth embodiment of the present disclosure.
[Fig. 46]

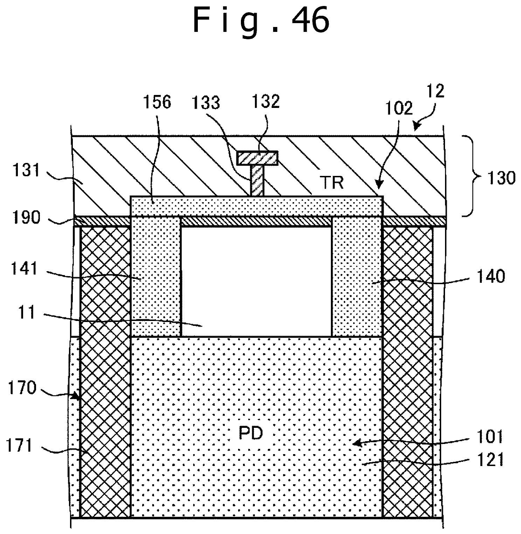

   Fig. 46 is a diagram depicting another configuration example of the pixel according to the sixth embodiment of the present disclosure.
[Fig. 47]

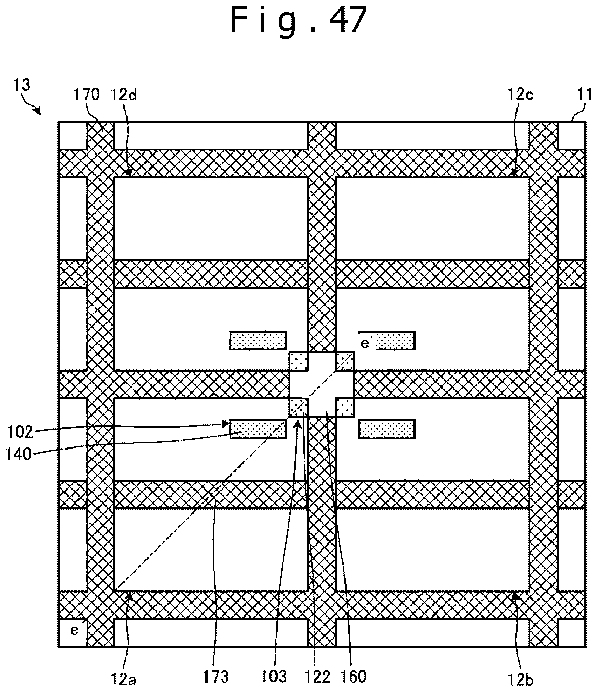

   Fig. 47 is a diagram depicting a configuration example of the pixels according to a seventh embodiment of the present disclosure.
[Fig. 48]

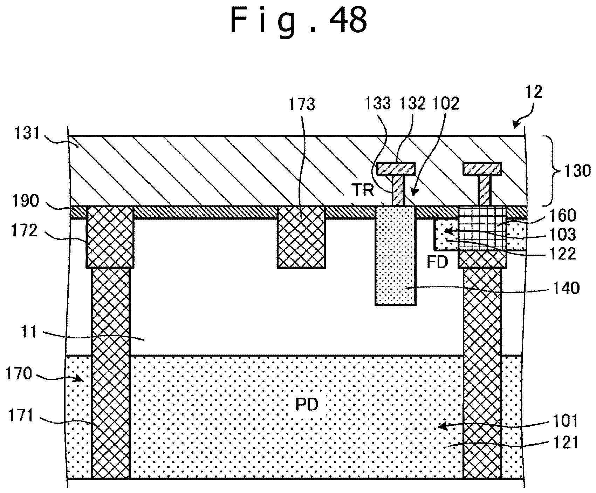

   Fig. 48 is a diagram depicting a configuration example of the pixel according to the seventh embodiment of the present disclosure.
[Fig. 49]

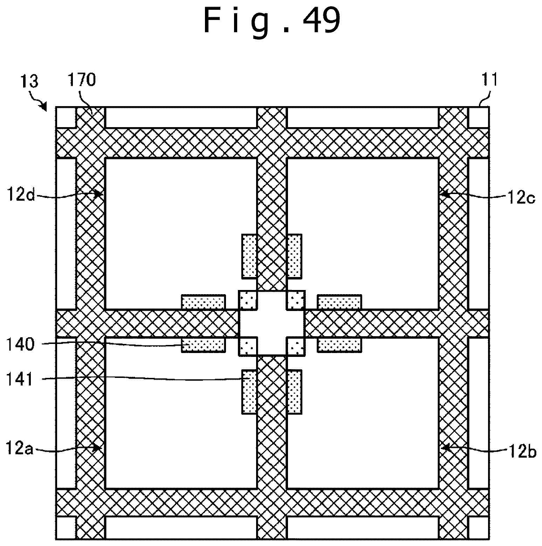

   Fig. 49 is a diagram depicting another configuration example of the pixels according to the seventh embodiment of the present disclosure.
[Fig. 50]

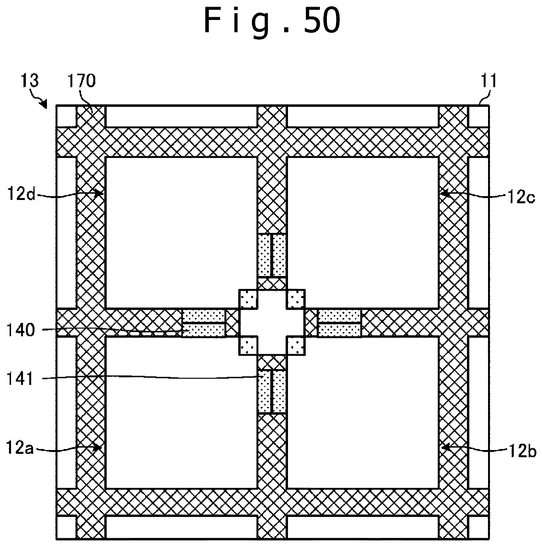

   Fig. 50 is a diagram depicting another configuration example of the pixels according to the seventh embodiment of the present disclosure.
[Fig. 51]

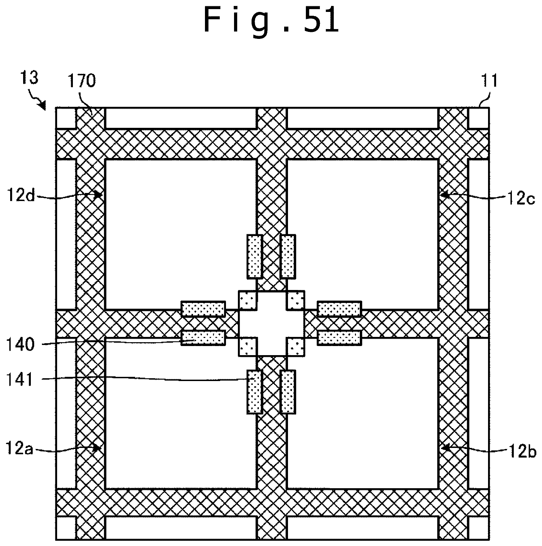

   Fig. 51 is a diagram depicting another configuration example of the pixels according to the seventh embodiment of the present disclosure.
[Fig. 52]

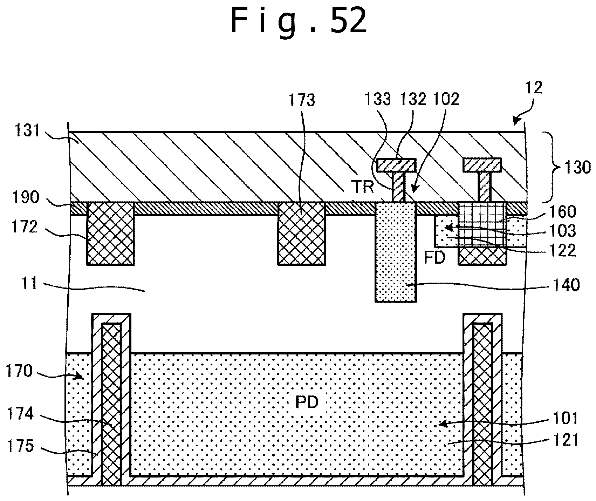

   Fig. 52 is a diagram depicting a configuration example of the pixel according to a ninth embodiment of the present disclosure.
[Fig. 53]

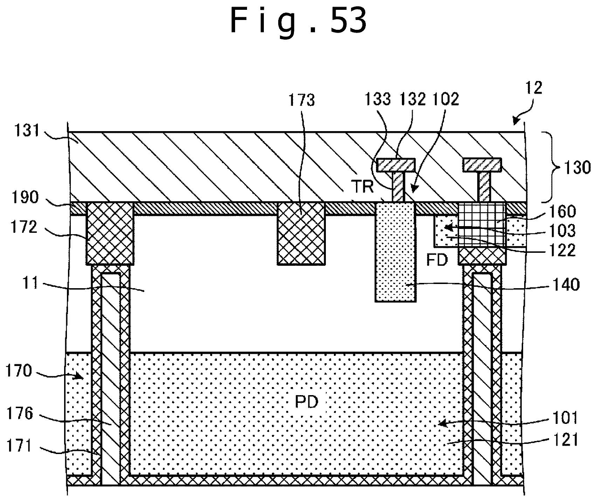

   Fig. 53 is a diagram depicting the configuration example of the pixel according to the ninth embodiment of the present disclosure.
[Fig. 54]

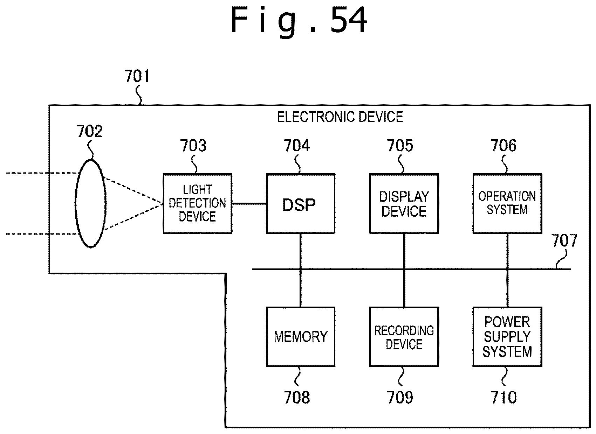

   Fig. 54 is a block diagram depicting a configuration example of an imaging device mounted on an electronic device.
[Fig. 55]

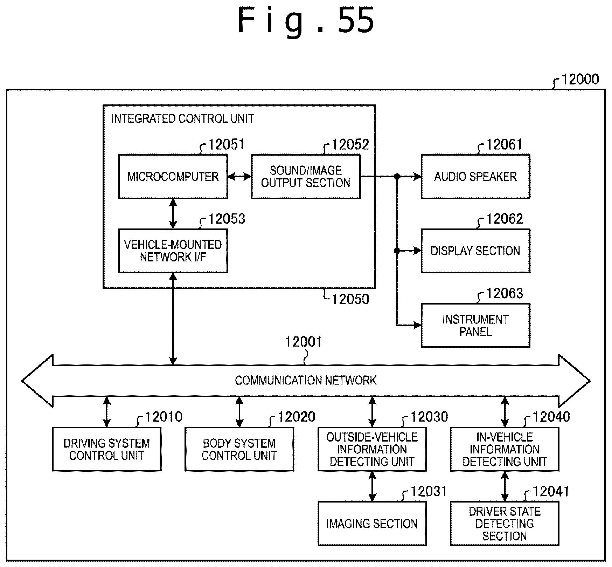

   Fig. 55 is a block diagram depicting an example of schematic configuration of a vehicle control system as an example of a mobile body control system to which the technology according to an embodiment of the present disclosure can be applied.
[Fig. 56]

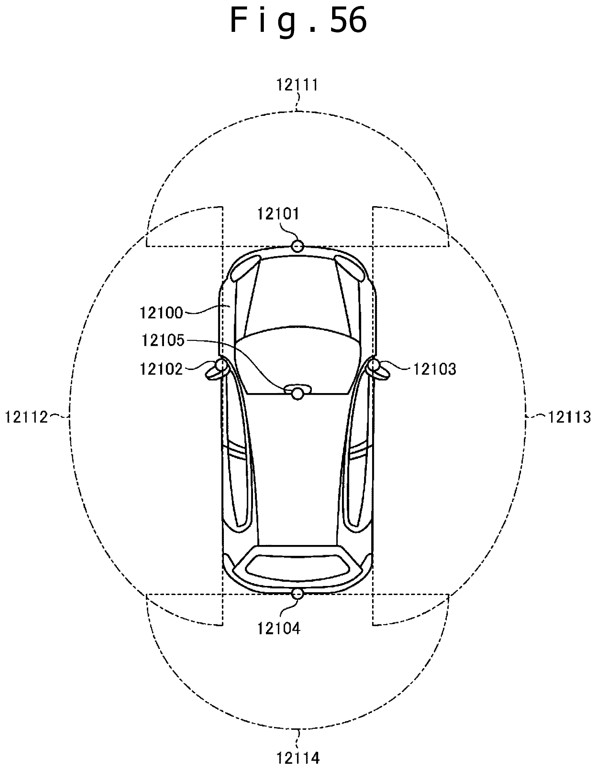

   Fig. 56 is an explanatory view depicting an example of an installation position of an imaging section.
[Fig. 57]

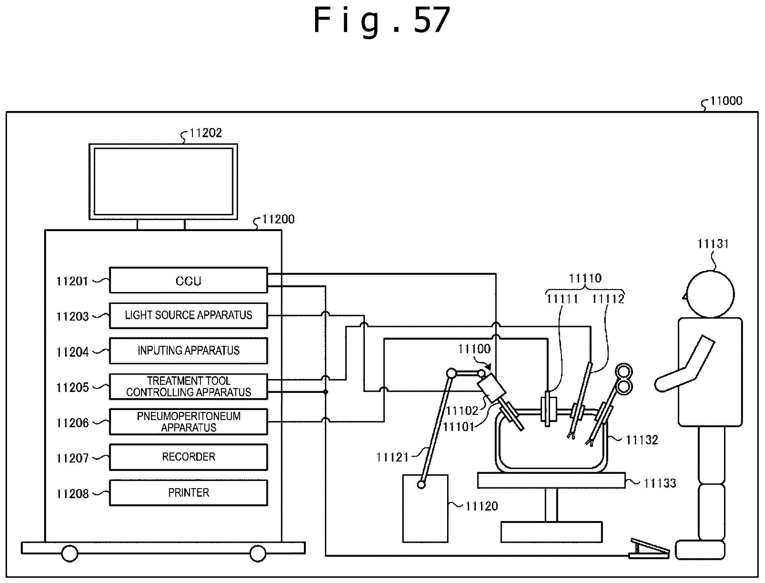

   Fig. 57 is a diagram depicting an example of schematic configuration of an endoscopic surgery system to which the technology according to the present disclosure (present technology) can be applied.
[Fig. 58]

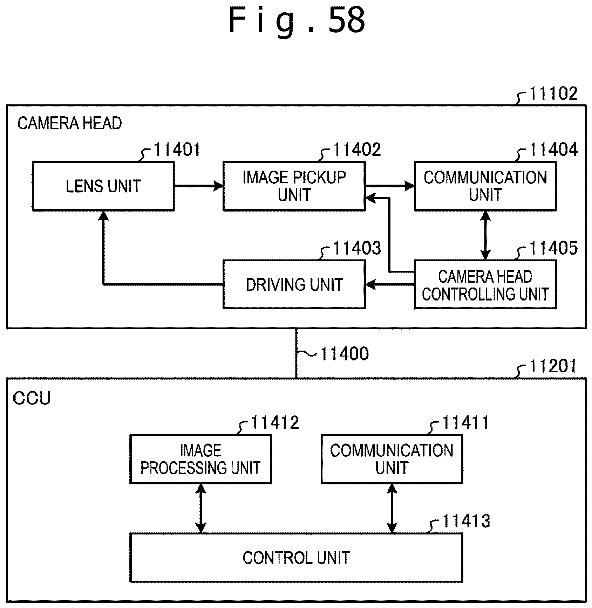

   Fig. 58 is a block diagram depicting an example of a functional configuration of a camera head and a CCU depicted in Fig. 57.

### Description of Embodiments

Hereinafter, embodiments of the present disclosure will be described in detail with reference to the drawings. Description will be made in the order below. It is to be noted that, in the following embodiments, the same areas are denoted by the same reference numerals, and redundant description thereof will be omitted.
1. First Embodiment
2. Second Embodiment
3. Third Embodiment
4. Fourth Embodiment
5. Fifth Embodiment
6. Sixth Embodiment
7. Seventh Embodiment
8. Eighth Embodiment
9. Ninth Embodiment
10. Configuration of Electronic Device
11. Application Example of Mobile Body
12. Application Example of Endoscopic Surgery System

### 1. First Embodiment

### Configuration of Light Detection Device

Fig. 1 is a diagram depicting an example of a schematic configuration of a light detection device according to an embodiment of the present disclosure. As depicted in Fig. 1, a light detection device 1 of the present example is configured to include a pixel array section (so-called imaging region) 13 in which pixels 12 including a plurality of photoelectric conversion sections are regularly arrayed two dimensionally on a semiconductor substrate 11, for example, a silicon substrate, and a peripheral circuit section. The pixel 12 includes a photodiode, for example, serving as a photoelectric conversion section, and a plurality of pixel transistors (so-called metal oxide semiconductor (MOS) transistors). The plurality of pixel transistors can be constituted of, for example, three transistors, namely, a transfer transistor, a reset transistor, and an amplification transistor. In addition, the plurality of pixel transistors can be constituted of four transistors by adding a selection transistor. The pixel 12 can have a shared pixel structure. This pixel shared structure is constituted of a plurality of photodiodes, a plurality of transfer transistors, one shared floating diffusion region, and one each of other shared pixel transistors. It is to be noted that the light detection device 1 is an example of a "semiconductor device" of the present disclosure.

The peripheral circuit section is configured to include a vertical drive circuit 33, a column signal processing circuit 34, a horizontal drive circuit 35, an output circuit 37, and a control circuit 36.

The control circuit 36 receives an input clock and data for providing instructions related to an operation mode and the like, and outputs data such as internal information of the imaging element. That is, the control circuit 36 generates a clock signal and a control signal that are references of operations of the vertical drive circuit 33, the column signal processing circuit 34, the horizontal drive circuit 35, and the like, on the basis of a vertical synchronization signal, a horizontal synchronization signal, and a master clock. Then, these signals are input to the vertical drive circuit 33, the column signal processing circuit 34, the horizontal drive circuit 35, and the like.

The vertical drive circuit 33 is constituted of, for example, a shift register, selects a pixel drive line 23, supplies a pulse for driving pixels to the selected pixel drive line 23, and drives the pixels in units of rows. That is, the vertical drive circuit 33 sequentially selects and scans the pixels 12 of a pixel region 3 in a vertical direction in units of rows to supply a pixel signal based on a signal charge generated in accordance with an amount of received light in, for example, a photodiode serving as the photoelectric conversion section of each pixel 12 to the column signal processing circuit 34 through a vertical signal line 24.

The column signal processing circuit 34 is disposed in each column of the pixels 12, for example, and performs signal processing such as noise removal on the signals output from the pixels 12 of one row for each pixel column. That is, the column signal processing circuit 34 performs signal processing such as correlated double sampling (CDS) for removing fixed pattern noise unique to the pixel 12, signal amplification, and analog-to-digital (AD) conversion. A horizontal selection switch (not illustrated) connected between the column signal processing circuit 34 and a horizontal signal line 38 is provided in an output stage of the column signal processing circuit 34.

The horizontal drive circuit 35 is constituted of, for example, a shift register, and sequentially selects each of the column signal processing circuits 34 by sequentially outputting a horizontal scanning pulse, and causes each of the column signal processing circuits 34 to output a pixel signal to the horizontal signal line 38.

The output circuit 37 performs signal processing on the signals sequentially supplied from the respective column signal processing circuits 34 through the horizontal signal line 38 and outputs the processed signals. For example, there may be cases in which only buffering is performed, or there may be cases in which black level adjustment, column variation correction, various digital signal processing, and the like are performed. An input/output terminal 39 exchanges signals with the outside.

It is to be noted that Fig. 1 depicts an example of a case in which the light detection device 1 is formed on the semiconductor substrate 11. The light detection device 1 can also be constituted of a plurality of semiconductor substrates. By layering the plurality of substrates constituting the light detection device 1, it is possible to reduce a size (area) of the light detection device 1. An example of this case will be described below.

### Other Configurations of Light Detection Device

Fig. 2 is a diagram depicting another example of a schematic configuration of the light detection device according to an embodiment of the present disclosure. The light detection device 1 in the drawing includes three substrates (first substrate 10, second substrate 20, and third substrate 30). The light detection device 1 has a three-dimensional structure configured by adhering the three substrates (first substrate 10, second substrate 20, and third substrate 30). The first substrate 10, the second substrate 20, and the third substrate 30 are layered in this order.

The first substrate 10 includes, on the semiconductor substrate 11, a plurality of the pixels 12 that perform photoelectric conversion. The plurality of pixels 12 are provided in a matrix in the pixel array section 13 of the first substrate 10. The second substrate 20 includes, on a semiconductor substrate 21, one pixel circuit 22 for every four pixels 12 that outputs a pixel signal based on a charge output from the pixels 12. The second substrate 20 includes a plurality of the pixel drive lines 23 extending in a row direction and a plurality of the vertical signal lines 24 extending in a column direction. The third substrate 30 includes, on a semiconductor substrate 31, a logic circuit 32 that processes a pixel signal. The logic circuit 32 includes, for example, the vertical drive circuit 33, the column signal processing circuit 34, the horizontal drive circuit 35, and the control circuit 36. The logic circuit 32 (specifically, horizontal drive circuit 35) outputs an output voltage Vout of each pixel 12 to the outside. In the logic circuit 32, for example, a low-resistance region made of silicide formed using a salicide (self-aligned silicide) process, such as CoSi₂ or NiSi, may be formed on a front surface of an impurity diffusion region in contact with a source electrode and a drain electrode.

The vertical drive circuit 33 sequentially selects a plurality of the pixels 12 in units of rows, for example. The column signal processing circuit 34 performs, for example, correlated double sampling (CDS) processing on the pixel signal output from each pixel 12 of the row selected by the vertical drive circuit 33. The column signal processing circuit 34 extracts a signal level of the pixel signal by performing, for example, CDS processing, and holds pixel data corresponding to an amount of light received by each pixel 12. The horizontal drive circuit 35 sequentially outputs, for example, the pixel data held in the column signal processing circuit 34 to the outside. The control circuit 36 controls, for example, the driving of each block (vertical drive circuit 33, column signal processing circuit 34, and horizontal drive circuit 35) in the logic circuit 32.

Fig. 3 is a diagram depicting a configuration example of the pixels according to an embodiment of the present disclosure. The drawing is a circuit diagram depicting a configuration example of the pixels 12, and depicts an example of the pixels 12 and the pixel circuit 22. Hereinafter, as depicted in Fig. 2, a case in which four pixels 12 share one pixel circuit 22 will be described. Here, "sharing" refers to the outputs of the four pixels 12 being input to the pixel circuit 22 common to the four pixels 12.

The pixels 12 include common constituent elements. In Fig. 2, to distinguish the constituent elements of each pixel 12 from each other, identification numbers (1, 2, 3, and 4) are added to the ends of the reference signs of the constituent elements of each pixel 12. In the following, an identification number is added to the end of the reference sign of the constituent element of each pixel 12 in a case in which it is necessary to distinguish the constituent elements of each pixel 12 from each other, but the identification number at the end of the reference sign of the constituent elements of each pixel 12 is omitted in a case in which it is not necessary to distinguish the constituent elements of each pixel 12 from each other.

Each pixel 12 includes, for example, a photodiode PD, a charge transfer section TR electrically connected to the photodiode PD, and a floating diffusion region (floating diffusion) FD constituting a charge holding section that temporarily holds charges output from the photodiode PD through the charge transfer section TR. The photodiode PD corresponds to a specific example of a "photoelectric conversion section" of the present disclosure. The photodiode PD performs photoelectric conversion to generate a charge corresponding to the amount of received light. A cathode of the photodiode PD is electrically connected to a source of the charge transfer section TR, and an anode of the photodiode PD is electrically connected to a reference potential line (ground, for example) . A drain of the charge transfer section TR is electrically connected to the floating diffusion region FD, and a gate of the charge transfer section TR is electrically connected to the pixel drive line 23. The charge transfer section TR is, for example, a metal oxide semiconductor (MOS) transistor.

The floating diffusion regions FD of the pixels 12 sharing one pixel circuit 22 are electrically connected to each other and are electrically connected to an input terminal of the common pixel circuit 22. The pixel circuit 22 includes, for example, a reset transistor RST, a selection transistor SEL, and an amplification transistor AMP. It is to be noted that the selection transistor SEL may be omitted as necessary. A source of the reset transistor RST (input terminal of pixel circuit 22) is electrically connected to the floating diffusion region FD, and a drain of the reset transistor RST is electrically connected to a power supply line VDD and a drain of the amplification transistor AMP. A gate of the reset transistor RST is electrically connected to the pixel drive line 23 (refer to Fig. 2). A source of the amplification transistor AMP is electrically connected to a drain of the selection transistor SEL, and a gate of the amplification transistor AMP is electrically connected to the source of the reset transistor RST. A source of the selection transistor SEL (output terminal of pixel circuit 22) is electrically connected to the vertical signal line 24, and a gate of the selection transistor SEL is electrically connected to the pixel drive line 23 (refer to Fig. 2).

When turned on, the charge transfer section TR transfers the charge of the photodiode PD to the floating diffusion region FD. The reset transistor RST resets the potential of the floating diffusion region FD to a predetermined potential. When turned on, the reset transistor RST resets the potential of the floating diffusion region FD to the potential of the power supply line VDD. The selection transistor SEL controls an output timing of the pixel signal from the pixel circuit 22. The amplification transistor AMP generates, as a pixel signal, a signal of a voltage corresponding to the level of the charge held in the floating diffusion region FD. The amplification transistor AMP constitutes a source follower type amplifier, and outputs a pixel signal of a voltage corresponding to the level of the charge generated in the photodiode PD. When the selection transistor SEL turns on, the amplification transistor AMP outputs a voltage corresponding to the potential of the floating diffusion region FD to the column signal processing circuit 34 via the vertical signal line 24. The reset transistor RST, the amplification transistor AMP, and the selection transistor SEL are, for example, MOS transistors.

An FD transfer transistor FDG may be provided between the source of the reset transistor RST and the gate of the amplification transistor AMP. The FD transfer transistor FDG is used when a conversion efficiency is switched. Typically, the pixel signal is small during imaging in a dark location. When charge-voltage conversion is performed on the basis of Q = CV, if the capacitance of the floating diffusion FD (FD capacitance C) is large, V at the time of conversion to voltage by the amplification transistor AMP is small. On the other hand, in a bright location, the pixel signal is large and thus, if the FD capacitance C is not large, the floating diffusion FD cannot fully receive the charge of the photodiode PD. Furthermore, the FD capacitance C needs to be large so that V at the time of conversion to voltage by the amplification transistor AMP is not too large (in other words, so that V is small) . Under these circumstances, when the FD transfer transistor FDG is turned on, the gate capacitance corresponding to the FD transfer transistor FDG is added, and thus the FD capacitance C as a whole increases. On the other hand, when the FD transfer transistor FDG is turned off, the FD capacitance C as a whole is small. Thus, the FD capacitance C can be made variable and the conversion efficiency can be switched by switching the FD transfer transistor FDG on and off.

It is to be noted that the column signal processing circuit 34 is an example of a "processing circuit" of the present disclosure. Further, the light detection device 1 is an example of an "electronic device" of the present disclosure.

### Configuration of Pixel

Fig. 4 is a diagram depicting a configuration example of the pixels according to the first embodiment of the present disclosure. The drawing is a diagram depicting a configuration example of the pixels 12 disposed in the pixel array section 13. Further, the drawing is a diagram depicting a configuration of the pixels 12 on a front surface side of the semiconductor substrate 11. In the semiconductor substrate 11 in the drawing, the four pixels 12 (pixel 12a, pixel 12b, pixel 12c, and pixel 12d) described in Fig. 3 are depicted. A photoelectric conversion section 101 (corresponding to PD in Fig. 2; not illustrated), a charge transfer section 102 (corresponding to TR in Fig. 3), and a charge holding section 103 (corresponding to FD in Fig. 2) are disposed in each of the pixels 12. It is to be noted that the charge holding section 103 is shared by the four pixels 12. A separation section 170 is disposed at the boundary between the pixels 12. The pixels 12a to 12d are configured in a square shape in a plan view. Here, "in a plan view" refers to a case of viewing from a normal direction of a front surface of the semiconductor substrate 11.

The charge holding section 103 is disposed in a central portion of the pixels 12a to 12d. In Fig. 4, a semiconductor region 122 constituting the charge holding section 103 is depicted. The semiconductor region 122 corresponds to the floating diffusion FD described above.

The charge transfer section 102 is disposed in the vicinity of the charge holding section 103 in the pixels 12a to 12d. The charge transfer section 102 will be described by using the pixel 12a as an example. The charge transfer section 102 includes vertical gates 140 and 141 and a plate electrode 159. The vertical gates 140 and 141 are gate electrodes constituted of a conductor embedded in the semiconductor substrate 11 and having a configuration in which charges are transferred in a thickness direction of the semiconductor substrate 11. The vertical gates 140 and 141 in Fig. 4 are depicted as an example of a case in which the vertical gates are configured in a rectangular shape in a plan view. Further, the pixel 12 in Fig. 4 is depicted as an example of a case in which the vertical gates 140 and 141 are disposed in parallel. Further, the vertical gates 140 and 141 in Fig. 4 is depicted as an example of a case in which the vertical gates are disposed in parallel with one of the sides of the separation section 170 adjacent to the charge holding section 103.

The plate electrode 159 is an electrode disposed on the front surface of the semiconductor substrate 11 on a front side and connected to the vertical gates 140 and 141. The dotted rectangle in Fig. 4 represents the plate electrode 159. It is to be noted that the configuration of the charge transfer section 102 is not limited to this example. For example, the vertical gates 140 and 141 can be configured to have an elliptical shape in a plan view. Further, for example, the vertical gates 140 and 141 can be configured to have different sizes.

Pixel transistors included in the pixel circuit 22 can be further disposed in the pixels 12a to 12d in Fig. 4. Here, the pixels 12a to 12d in Fig. 4 are depicted as an example of a case in which the pixel circuit 22 includes four of the amplification transistors AMP and two of the selection transistors SEL. In the pixel 12a of Fig. 4, the amplification transistor AMP and the reset transistor RST are disposed. In the pixel 12b, the amplification transistor AMP and the FD transfer transistor FDG are disposed. In the pixel 12c, the amplification transistor AMP and the selection transistor SEL are disposed. In the pixel 12d, the amplification transistor AMP and the selection transistor SEL are disposed. These pixel transistors can be disposed in the vicinity of the side of the separation section 170 facing the side close to the vertical gates 140 and 141.

### Configuration of Cross Section of Pixel

Fig. 5 is a diagram depicting a configuration example of the pixel according to the first embodiment of the present disclosure. The drawing is a cross-sectional view depicting a configuration example of the pixel 12. The pixel 12 in the drawing includes the semiconductor substrate 11, a wiring region 130, a color filter 192, and an on-chip lens 193. It is to be noted that the drawing schematically depicts a shape of a cross section taken along line a-a' in Fig. 4.

The semiconductor substrate 11 is a semiconductor substrate on which the photoelectric conversion section 101 and the like are disposed. The semiconductor substrate 11 can be formed of, for example, silicon (Si). The photoelectric conversion section 101 is disposed in a well region formed in the semiconductor substrate 11. For convenience, it is assumed that the semiconductor substrate 11 of Fig. 5 constitutes a p-type well region. By disposing n-type and p-type semiconductor regions in this p-type well region, it is possible to form (a diffusion layer of) an element. The rectangles depicted in the semiconductor substrate 11 of Fig. 5 represent semiconductor regions.

The photoelectric conversion section 101 is constituted of an n-type semiconductor region 121. Specifically, a photodiode having a pn junction formed at an interface between the n-type semiconductor region 121 and a surrounding p-type semiconductor region or a well region corresponds to the photoelectric conversion section 101. As depicted in Fig. 5, the photoelectric conversion section 101 is disposed in the vicinity of the front surface of the semiconductor substrate 11 on a back side.

The charge holding section 103 is constituted of the n-type semiconductor region 122 having a relatively high impurity concentration. This n-type semiconductor region 122 corresponds to the floating diffusion FD.

The charge transfer section 102 is constituted of the semiconductor regions 121 and 122 and the vertical gates 140 and 141. The n-type semiconductor regions 121 and 122 correspond to a source region and a drain region of the charge transfer section 102. The vertical gates 140 and 141 are disposed on the front surface side of the semiconductor substrate 11 and are formed in a columnar shape embedded in the semiconductor substrate 11. Further, the vertical gates 140 and 141 are formed to a depth such that bottom portions thereof reach the vicinity of the n-type semiconductor region 121. When a drive voltage is applied to the vertical gates 140 and 141, channels are formed in the semiconductor regions on front surfaces of the vertical gates 140 and 141, and the n-type semiconductor regions 121 and 122 are brought into a conductive state. That is, the photoelectric conversion section 101 and the charge holding section 103 are electrically connected to each other, and the charge of the photoelectric conversion section 101 is transferred to the charge holding section 103. Thus, the charge transfer section 102 transfers the charge in the thickness direction of the semiconductor substrate 11. The vertical gates 140 and 141 can be formed of polycrystalline silicon containing impurities. It is to be noted that the semiconductor region 121 is an example of a "first semiconductor region" of the present disclosure. The semiconductor region 122 is an example of a "second semiconductor region" of the present disclosure.

The separation section 170 is disposed in the semiconductor substrate 11 at the boundary between the pixels 12. The separation section 170 electrically and optically separates the pixels 12 from each other. The separation section 170 of Fig. 5 includes a first separation section 171 and a second separation section 172. The first separation section 171 is constituted of an insulating member disposed in an opening having a groove shape extending through the semiconductor substrate 11. Further, the second separation section 172 is constituted of an insulating member disposed in an opening having a groove shape formed in the front surface of the semiconductor substrate 11 on the front side. This second separation section 172 corresponds to shallow trench isolation (STI) . It is to be noted that the second separation section 172 in Fig. 5 is formed at a position overlapping the first separation section 171. The first separation section 171 and the second separation section 172 can be formed of, for example, silicon oxide (SiO₂).

It is to be noted that a semiconductor region (not illustrated) configured to have a high impurity concentration can be disposed in the semiconductor substrate 11 adjacent to the separation section 170. This semiconductor region corresponds to a pinning region that pins an interface state of the semiconductor substrate 11.

Insulating films 190 and 191 are disposed on the front surface side and a back surface side of the semiconductor substrate 11, respectively. These insulating films 190 and 191 can be formed of, for example, silicon oxide (SiO₂) or silicon nitride (SiN) . It is to be noted that the insulating film 190 between the vertical gates 140 and 141 and the semiconductor substrate 11 corresponds to a gate insulating film.

The wiring region 130 is a region disposed on the front surface of the semiconductor substrate 11 on the front side where a wiring line that transmits signals of an element or the like is disposed. The wiring region 130 in Fig. 5 includes an insulating layer 131 and a wiring line 132. The insulating layer 131 insulates the electrodes, the wiring line 132, and the like disposed on the front surface of the semiconductor substrate 11. This insulating layer 131 can be formed of SiO₂, for example. The wiring line 132 transmits a signal or the like to an element. This wiring line 132 can be formed of a metal such as copper (Cu) or tungsten (W), for example. Further, a contact plug 133 is further disposed in the wiring region 130. This contact plug 133 electrically connects the wiring line 132 and a member of the semiconductor substrate 11 or the like. This contact plug 133 can be formed of W or the like having a columnar shape, for example.

The color filter 192 is an optical filter that transmits, among incident light, light having a predetermined wavelength. As the color filter 192, a color filter that transmits red light, green light, and blue light can be used, for example.

The on-chip lens 193 is a lens that condenses incident light. This on-chip lens 193 is configured in a hemispherical shape, for example, and condenses incident light on the photoelectric conversion section 101 and the like.

As depicted in Fig. 4 and Fig. 5, the vertical gates 140 and 141 of the charge transfer section 102 are disposed in parallel. This makes it possible to align plane orientations of surfaces of the semiconductor substrate 11 in contact with the vertical gates 140 and 141. When the plane orientation of the front surface of the semiconductor substrate 11 is the (100) plane, the plane orientations of the surfaces of the semiconductor substrate 11 in contact with the vertical gates 140 and 141 can be set to either the (100) plane or the (110) plane. With the vertical gates 140 and 141 disposed in parallel in a plan view, the corresponding surfaces of the vertical gates 140 and 141 come into contact with the semiconductor substrate 11 in the same orientation plane. This makes it possible to make the characteristics of the vertical gates 140 and 141 uniform.

As described above, the gate insulating film is disposed between the vertical gates 140 and 141 and the semiconductor substrate 11. This gate insulating film is formed of SiO₂ and formed by thermal oxidation. A growth rate of this SiO₂ film in this thermal oxidation differs depending on the plane orientation of the semiconductor substrate 11. Specifically, it is known that the growth rate of SiO₂ is higher on the (110) plane than on the (100) plane. Therefore, the SiO₂ film of the (110) plane is formed thicker than the SiO₂ film of the (100) plane. A thickness of the SiO₂ film constituting this gate oxide film affects characteristics such as threshold voltage. However, in a case in which the vertical gates 140 and 141 are disposed in parallel, the film thicknesses of the gate oxide films formed on the corresponding surfaces can be made uniform. This makes it possible to make the characteristics of the vertical gates 140 and 141 uniform.

When a size (area) of the pixel 12 is reduced to enhance the definition of an imaging element, a charge amount (saturation charge amount) that can be accumulated in the photoelectric conversion section 101 of the pixel 12 decreases. By increasing (deepening) the potential of the n-type semiconductor region 121 constituting the photoelectric conversion section 101, it is possible to compensate for the amount of decrease in the saturation charge amount. Transfer of the charge from the n-type semiconductor region 121 having this deep potential is required. When the gate voltage of the charge transfer section 102 is increased to address this, an electric field in the vicinity of the vertical gates 140 and 141 of the charge transfer section 102 is made stronger, causing problems such as an increase in leakage current. Therefore, by disposing a plurality of vertical gates (vertical gates 140 and 141) to improve charge transfer performance, it is possible to transfer the charge of the photoelectric conversion section 101 to the charge holding section 103 while preventing an increase in gate voltage.

However, in a case in which the characteristics of the vertical gates 140 and 141 are not uniform, the charge transfer performance is reduced. For example, in a case in which the threshold voltages of the vertical gates 140 and 141 differ from each other, only one of the vertical gates 140 and 141 may be conductive and the other may be non-conductive, depending on the gate voltage. In this case, the charge transfer performance of the charge transfer section 102 is reduced.

Therefore, as described above, the vertical gates 140 and 141 are disposed in parallel to each other to make the characteristics uniform. This can improve the charge transfer performance of the charge transfer section 102 including the vertical gates 140 and 141.

Further, the pixel 12 is formed in a rectangular shape, and the charge holding section 103 is disposed at a corner portion of the pixel 12. The vertical gates 140 and 141 are disposed in a direction toward this charge holding section 103. This makes it possible to improve a transfer efficiency of the charge. This is because the region of the semiconductor substrate 11 between the vertical gates 140 and 141 serves as a flow path of charges, and the flow path is formed in a direction toward the charge holding section 103. Further, as depicted in Fig. 4, the vertical gates 140 and 141 are disposed close to a side of the separation section 170 in contact with the charge holding section 103 and parallel to that side, making it possible to limit the region of the charge transfer section 102 to the vicinity of the side in contact with the charge holding section 103. This forms a relatively wide vacant region in the vicinity of the side facing the side close to the vertical gates 140 and 141. This makes it possible to dispose the pixel transistors in this vacant region and reduce the size of the light detection device 1.

In contrast, in a case in which the vertical gates 140 and 141 are each disposed at an angle of 45 degrees relative to the side of the separation section 170 in contact with the charge holding section 103, the vertical gates 140 and 141 each have a shape protruding toward the central portion of the pixel 12. The region of the charge transfer section 102 is then large, making it difficult to dispose the pixel transistors in the pixel 12. In this case, the pixel circuit 22 is disposed in a region different from that of the pixels 12, increasing the size of the light detection device 1.

### Method for Manufacturing Light Detection Device

Figs. 6A to 6F are diagrams depicting an example of a manufacturing method of the light detection device according to the first embodiment of the present disclosure. Figs. 6A to 6F are diagrams depicting an example of manufacturing processes of a portion of the pixel 12 in the light detection device 1, which is a semiconductor device. First, the n-type semiconductor region 121 and the like are formed in the semiconductor substrate 11. Subsequently, the first separation section 171 and the second separation section 172 are formed in this order (Fig. 6A).

Subsequently, a resist 400 is disposed on the front surface of the semiconductor substrate 11. In the resist 400, openings 401 and 402 are disposed at positions where the vertical gates 140 and 141 are to be formed (Fig. 6B).

Subsequently, the semiconductor substrate 11 is etched by using the resist 400 as a mask to form openings 403 and 404 (Fig. 6C).

Subsequently, the resist 400 is removed (Fig. 6D). Subsequently, a gate insulating film 199 is formed on wall surfaces of the openings 403 and 404 (Fig. 6E). This can be performed by forming a SiO₂ film as a material of the gate insulating film 199 on the front surface of the semiconductor substrate 11 including the openings 403 and 404, and removing the unnecessary SiO₂ film other than that on the wall surfaces of the openings 403 and 404. The SiO₂ film can be formed by thermal oxidation. Further, the removal of the unnecessary SiO₂ film can be performed by, for example, chemical mechanical polishing (CMP).

Subsequently, the vertical gates 140 and 141 are formed (Fig. 6F). This can be performed by forming a polycrystalline silicon film as a material of the vertical gates 140 and 141 on the front surface of the semiconductor substrate 11 including the openings 403 and 404 and removing unnecessary polycrystalline silicon film other than that on the openings 403 and 404. The removal of the unnecessary polycrystalline silicon film can be performed by CMP. Subsequently, the wiring region 130 and the like are formed. Through the above process, the pixel 12 can be formed.

Thus, in the light detection device 1 according to the first embodiment of the present disclosure, the vertical gates 140 and 141 of the charge transfer section 102 are disposed in parallel, making it possible to make the characteristics of the vertical gates 140 and 141 uniform. This can improve the transfer efficiency of the charge and improve the light detection characteristics of the pixel 12.

### 2. Second Embodiment

Variations of the charge transfer section 102 according to the first embodiment described above will now be described.

### Configuration of Pixel

Figs. 7 to 14 are diagrams depicting configuration examples of the pixels according to a second embodiment of the present disclosure. Figs. 7 to 14, similarly to Fig. 4, are diagrams depicting configuration examples of the pixels 12 disposed in the pixel array section 13.

Fig. 7 depicts an example of the pixel 12 having a shape obtained by rotating the pixel 12 of Fig. 4 by 90 degrees.

Fig. 8 depicts an example in which the vertical gates 140 and 141 parallel to each other are each disposed at an angle of less than 45 degrees relative to the side of the separation section 170. The vertical gates 140 and 141 in the drawing are depicted as an example of a case in which the vertical gates are each disposed at an angle of 30 degrees relative to the side of the separation section 170.

Fig. 9 depicts an example of the pixel 12 having a shape obtained by rotating the pixel 12 of Fig. 8 by 90 degrees.

Fig. 10 depicts an example of a case in which the vertical gates 140 and 141 of one pixel 12 among the four pixels 12 sharing the charge holding section 103 are disposed in a direction different from that of the other pixels 12. In the drawing, the vertical gates 140 and 141 of the pixel 12c, among the pixel 12a, the pixel 12b, the pixel 12c, and the pixel 12d, are disposed in a direction perpendicular to the vertical gates 140 and 141 of the pixel 12a, the pixel 12b, and the pixel 12d.

Fig. 11 depicts an example in which the vertical gates 140 and 141 of the four pixels 12 sharing the charge holding section 103 are configured to have different lengths. In the drawing, an example is depicted in which the direction of the vertical gates 140 and 141 of the pixel 12a and the pixel 12c and the direction of the vertical gates 140 and 141 of the pixel 12b and the pixel 12d differ by 90 degrees.

Fig. 12 depicts an example of a case in which the vertical gates 140 and 141 parallel to each other are each disposed at an angle of less than 45 degrees relative to the side of the separation section 170 and the vertical gate 140 is shorter than the vertical gate 141. Here, the vertical gate 141 represents a vertical gate close to the side of the separation section 170, and the vertical gate 140 represents a vertical gate disposed away from the side of the separation section 170. By adopting such a configuration, it is possible to widen an entrance portion of the flow path of the charge between the vertical gates 140 and 141. This makes it possible to transfer the charge within a wide range of the n-type semiconductor region 121 constituting the photoelectric conversion section 101. The fan-shaped area indicated by the dashed-dotted line in the drawing represents the transfer range of the charge.

Fig. 13 depicts an example of a case in which the pixel 12a, the pixel 12b, the pixel 12c, and the pixel 12d individually include the charge holding section 103.

Fig. 14 depicts an example in which the pixel transistors of the pixel circuit 22 are disposed in one pixel 12. In the pixel 12d in the drawing, the amplification transistor AMP, the reset transistor RST, and the selection transistor SEL are disposed. It is to be noted that a circuit in which the FD transfer transistor FDG is omitted can be applied to the pixel circuit 22.

Other configurations of the light detection device 1 are similar to the configurations of the light detection device 1 in the first embodiment of the present disclosure, and thus the description thereof will be omitted.

### 3. Third Embodiment

The light detection device 1 of the first embodiment described above includes the vertical gates 140 and 141 disposed in parallel. In contrast, the light detection device 1 according to a third embodiment of the present disclosure differs from that in the first embodiment described above in that facing surfaces of the vertical gates 140 and 141 disposed close to each other are parallel to each other.

### Configuration of Pixel

Fig. 15 is a diagram depicting a configuration example of the pixel according to the third embodiment of the present disclosure. The drawing is a diagram depicting a configuration example of the pixel 12. Further, the drawing is a diagram depicting a configuration of the pixel 12 on the front surface side of the semiconductor substrate 11. Further, the pixel 12 in the drawing corresponds to any one of the pixels 12 (pixel 12a, pixel 12b, pixel 12c, and pixel 12d) in Fig. 4. The pixel 12 in this drawing differs from the pixel 12 in Fig. 4 in including the vertical gates 140 and 141, each having a triangular shape in a plan view.

As described above, the vertical gates 140 and 141 are configured such that the facing surfaces are parallel to each other. In the pixel 12 of Fig. 15, a surface 144 of the vertical gate 140 and a surface 145 of the vertical gate 141 correspond to the surfaces facing each other. These surfaces 144 and 145 are parallel. This makes it possible to configure the gate insulating films adjacent to the surfaces 144 and 145 to have substantially the same thickness and make characteristics uniform.

Further, the region of the semiconductor substrate 11 between the surfaces 144 and 145 constitutes a flow path of the charge. The flow path of the charge is configured at an angle of less than 45 degrees relative to the side of the separation section 170. That is, the vertical gates 140 and 141 are each configured in the shape of a right triangle in which lengths of sides other than the oblique side differ in a plan view, and are disposed at positions where the oblique sides face each other.

It is to be noted that Fig. 15 depicts an example of a case in which a region configured to have a deep potential in the n-type semiconductor region 121 constituting the photoelectric conversion section 101 is disposed in the vicinity of the entrance of the flow path of the charge between the surfaces 144 and 145. The dashed-dotted line in Fig. 15 indicates this deep potential region 123. Adoption of such a configuration facilitates collection of the charge of the photoelectric conversion section 101, making it possible to improve the transfer efficiency of the charge.

Further, by configuring the respective surfaces 144 and 145 of the vertical gates 140 and 141 to be less than 45 degrees relative to the side of the separation section 170, it is possible to expand a vacant region on the front surface of the semiconductor substrate 11 in the pixel 12. In the region, the pixel transistors of the pixel circuit 22 can be disposed. The dotted line in Fig. 15 indicates a region 300 in which the pixel transistors are disposed. In the pixel 12 in Fig. 15, the region 300 is expanded, making it possible to dispose a large number of the pixel transistors.

It is to be noted that the vertical gates 140 and 141 in Fig. 15 are each depicted as an example in which the contact plug 133 is connected.

### Configuration of Cross Section of Pixel

Fig. 16 is a diagram depicting a configuration example of the pixel according to the third embodiment of the present disclosure. The drawing, similarly to Fig. 5, is a cross-sectional view depicting a configuration example of the pixel 12. It is to be noted that the drawing schematically depicts a shape of a cross section taken along line b-b' in Fig. 15. In the drawing, a deep potential region 123 and the region 300 in which the pixel transistors are disposed are depicted. It is to be noted that a separation region 124 is disposed around the region 300. This separation region 124 is a semiconductor region configured to have a relatively high p-type impurity concentration.

In Fig. 16, a dotted rectangle and a dashed-dotted rectangle represent the position of the vertical gate 141 and the region 123 in a case in which the respective surfaces 144 and 145 of the vertical gates 140 and 141 are configured to be at 45 degrees relative to the sides of the separation section 170. In this case, the vertical gates 140 and 141 are close to the region 123, increasing an electric field with the region 123 when a drive voltage is applied to the vertical gate 141. This causes problems such as an increase in leakage current.

### Other Configuration of Pixel

Fig. 17 is a diagram depicting another configuration example of the pixel according to the third embodiment of the present disclosure. The drawing, similarly to Fig. 15, is a diagram depicting a configuration example of the pixel 12. Further, the pixel 12 in the drawing is depicted as an example in which the facing surfaces of the vertical gates 140 and 141 are constituted of curved surfaces.

Other configurations of the light detection device 1 are similar to the configurations of the light detection device 1 in the first embodiment of the present disclosure, and thus the description thereof will be omitted.

Thus, in the light detection device 1 according to the third embodiment of the present disclosure, the facing surfaces of the vertical gates 140 and 141 are configured to be parallel to each other. This can improve the transfer efficiency of the charge and improve the light detection characteristics of the pixel 12.

### 4. Fourth Embodiment

The light detection device 1 according to the third embodiment described above includes the vertical gates 140 and 141 having the same size. In contrast, the light detection device 1 according to a fourth embodiment of the present disclosure differs from that of the first embodiment described above in including the vertical gates 140 and 141 configured to have different sizes.

### Configuration of Pixel

Fig. 18 is a diagram depicting a configuration example of the pixel according to the fourth embodiment of the present disclosure. The drawing, similarly to Fig. 15, is a diagram depicting a configuration example of the pixel 12. The pixel 12 in the drawing differs from the pixel 12 in Fig. 15 in including the vertical gates 140 and 141 configured to have different sizes. It is to be noted that an element separation section 173 is disposed in the pixel 12 in the drawing. This element separation section 173 is disposed on the front surface of the semiconductor substrate 11 and separates the charge holding section 103 and the charge transfer section 102 from the other pixel transistors. In the drawing, the amplification transistor AMP is depicted as the pixel transistor. The element separation section 173 can be formed by STI.

The vertical gates 140 and 141 in Fig. 18 are depicted as an example where they are formed in a triangular shape in a plan view. Similarly to the vertical gates 140 and 141 of Fig. 15, the surface 144 of the vertical gate 140 and the surface 145 of the vertical gate 141 in Fig. 18 are disposed in parallel. This makes it possible to configure the gate insulating films adjacent to the surfaces 144 and 145 to have substantially the same thickness and make characteristics uniform.

In the pixel 12 according to the fourth embodiment of the present disclosure, one of the vertical gates 140 and 141 is configured to have a size smaller than that of the other. In Fig. 18, the vertical gate 140 is configured to have a size smaller than that of the vertical gate 141. The dotted line in Fig. 18 indicates the vertical gate 141 in a case of being formed to have the same size as that of the vertical gate 141. By reducing the size of the vertical gate 140, it is possible to expand the region where the pixel transistors are disposed.

### Configuration of Cross Section of Pixel

Fig. 19 is a diagram depicting a configuration example of the pixel according to the fourth embodiment of the present disclosure. The drawing, similarly to Fig. 16, is a schematic cross-sectional view depicting a configuration example of the pixel 12. The separation section 170 in the drawing is constituted of the first separation section 171. In the pixel 12 in the drawing, a semiconductor region 125 adjacent to this first separation section 171 is disposed. This semiconductor region 125 is a semiconductor region configured to have a relatively high p-type impurity concentration, and is a region for pinning the interface state of the semiconductor substrate 11. Further, a semiconductor region 126 configured to have a relatively high p-type impurity concentration is also disposed in a layer below the region 300 of the semiconductor substrate 11 in which the pixel transistors are disposed. This semiconductor region 126 separates the region 300 and the semiconductor region 121 from each other. It is to be noted that the semiconductor region 125 is an example of a "third semiconductor region" of the present disclosure.

A plate electrode 158 (not illustrated in Fig. 18) is connected to the vertical gate 140, and a plate electrode 157 (not illustrated in Fig. 18) is disposed on the vertical gate 141. As depicted in Fig. 19, the vertical gate 140 is configured to have size smaller than that of the vertical gate 141. Specifically, the vertical gate 140 is configured to have a shape that is narrower and, in a depth direction of the semiconductor substrate 11, shorter than that of the vertical gate 140. By reducing the width of the vertical gate 140, it is possible to expand the region 300. Further, by shortening the vertical gate 140 in the depth direction of the semiconductor substrate 11, it is possible to expand the semiconductor region 121 constituting the photoelectric conversion section 101 to the front surface side of the semiconductor substrate 11. This makes it possible to improve a saturation charge amount of the photoelectric conversion section 101.

### Other Configuration of Pixel

Fig. 20 is a diagram depicting another configuration example of the pixel according to the fourth embodiment of the present disclosure. The drawing, similarly to Fig. 18, is a diagram depicting a configuration example of the pixel 12. The pixel 12 in the drawing differs from the pixel 12 in Fig. 18 in that the element separation section 173 is disposed at a position overlapping the region of the vertical gate 140. Part of the vertical gate 140 in the drawing is formed in the region of the element separation section 173.

### Configuration of Cross Section of Pixel

Fig. 21 is a diagram depicting another configuration example of the pixel according to the fourth embodiment of the present disclosure. The drawing, similarly to Fig. 19, is a schematic cross-sectional view depicting a configuration example of the pixel 12. The pixel 12 in the drawing differs from the pixel 12 in Fig. 19 in that part of the vertical gate 140 is formed in the region of the element separation section 173. The vertical gate 140 in the drawing can be formed by, for example, forming an opening in the front surface of the semiconductor substrate 11 including part of the element separation section 173 and embedding a material film in the opening in the manufacturing process of the pixel 12. Thus, the region 300 in which the pixel transistors are disposed can be further expanded by moving the position of the element separation section 173 in the direction of the charge holding section 103 and forming the vertical gate 140 at a position overlapping the region of the element separation section 173.

### Other Configuration of Pixel

Fig. 22 is a diagram depicting another configuration example of the pixel according to the fourth embodiment of the present disclosure. The drawing, similarly to Fig. 18, is a diagram depicting a configuration example of the pixel 12. The pixel 12 in the drawing differs from the pixel 12 in Fig. 18 in that the vertical gates 140 and 141 are configured to have a rectangular shape in a plan view. Further, the vertical gates 140 and 141 in the drawing are disposed in parallel.

### Configuration of Cross Section of Pixel

Fig. 23 is a diagram depicting another configuration example of the pixel according to the fourth embodiment of the present disclosure. The drawing, similarly to Fig. 19, is a schematic cross-sectional view depicting a configuration example of the pixel 12. The pixel 12 in the drawing differs from the pixel 12 in Fig. 19 in that the vertical gate 141 is disposed adjacent to the semiconductor region 125. As described above, the semiconductor region 125 is a semiconductor region configured to have a relatively high p-type impurity concentration. When the impurities of the semiconductor region 125 diffuse into the semiconductor substrate 11, the dimensions of the well region of the semiconductor substrate 11 and the semiconductor region 121 constituting the photoelectric conversion section 101 is narrowed. Here, the vertical gate 141 configured to have a long size in the depth direction of the semiconductor substrate 11 is disposed adjacent to the semiconductor region 125, making it possible to prevent the diffusion of the impurities from the semiconductor region 125. This makes it possible to prevent a reduction in size of the region of the photoelectric conversion section 101, and prevent a reduction in the saturation charge amount and a reduction in sensitivity.

### Modifications

Fig. 24 is a diagram depicting another configuration example of the pixel according to a modification of the fourth embodiment of the present disclosure. The drawing, similarly to Fig. 18, is a diagram depicting a configuration example of the pixel 12. The pixel 12 in the drawing differs from the pixel 12 in Fig. 18 in including the vertical gate 140 configured in a triangular shape in a plan view and the vertical gate 141 configured in a rectangular shape in a plan view. It is to be noted that the vertical gate 140 is configured to have a shape shorter than that of the vertical gate 141 in the depth direction of the semiconductor substrate 11.

The vertical gate 141 in Fig. 24 includes the surface 145 parallel to the side of the separation section 170. Further, the vertical gate 140 in Fig. 24 includes the surface 144 at an angle of 45 degrees relative to the side of the separation section 170. The semiconductor substrate 11 in contact with the surface 145 and the surface 144 can have an orientation plane that improves the transfer efficiency of the charge.

Other configurations of the light detection device 1 are similar to the configurations of the light detection device 1 in the first embodiment of the present disclosure, and thus the description thereof will be omitted.

Thus, in the light detection device 1 according to the fourth embodiment of the present disclosure, the facing surfaces of the vertical gates 140 and 141 are configured to be parallel to each other. This can improve the transfer efficiency of the charge and improve the light detection characteristics of the pixel 12.

### 5. Fifth Embodiment

The light detection device 1 according to the first embodiment described above includes the two vertical gates 140 and 141. In contrast, the light detection device 1 according to a fifth embodiment of the present disclosure differs from that of the first embodiment described above in including three vertical gates.

### Configuration of Pixel

Fig. 25 is a diagram depicting a configuration example of the pixel according to the fifth embodiment of the present disclosure. The drawing, similarly to Fig. 15, is a diagram depicting a configuration example of the pixel 12. The pixel 12 in the drawing differs from the pixel 12 in Fig. 15 in including the vertical gates 140 and 141 disposed close to the charge holding section 103 and the vertical gate 142 disposed in the vicinity of the center portion of the pixel 12.

The vertical gate 140 is disposed adjacent to one of two sides of the separation section 170 close to the charge holding section 103, and the vertical gate 141 is disposed adjacent to the other side of the separation section 170 close to the charge holding section 103. Further, the vertical gates 140 and 141 are configured in a triangular shape in a plan view. The vertical gates 140 and 141 are disposed in shapes in which surfaces corresponding to oblique sides of the triangular shapes face each other. Further, the vertical gates 140 and 141 are configured so that these facing surfaces are tapered in a plan view. Accordingly, the flow path of the charge between the vertical gates 140 and 141 is configured in a shape in which the entrance is wider than the exit disposed in the direction of the charge holding section 103. Therefore, when a drive voltage is applied to the vertical gates 140 and 141, an electric field having a gradient corresponding to a distance between the vertical gates 140 and 141 can be formed.

The vertical gate 142 in Fig. 25 is depicted as an example of being configured in a circular shape in a plan view. The vertical gate 142 is disposed on the opposite side from the charge holding section 103 relative to the vertical gates 140 and 141, and is disposed in the vicinity of the entrance of the charge flow path formed by the vertical gates 140 and 141. Thus, the vertical gates 140 and 141 are disposed between the vertical gate 142 and the semiconductor region 122 constituting the charge holding section 103. It is to be noted that the vertical gate 140 and the vertical gate 141 are examples of the "first vertical gate" and the "second vertical gate" in the present disclosure. The vertical gate 142 is an example of a "third vertical gate" of the present disclosure.

### Configuration of Cross Section of Pixel

Figs. 26A and 26B are diagrams depicting a configuration example of the pixel according to the fifth embodiment of the present disclosure. Figs. 26A and 26B, similarly to Fig. 16, are schematic cross-sectional views depicting the configuration example of the pixel 12. Fig. 26A depicts a shape of a cross section of the pixel 12 of Fig. 25 taken along line c-c' , and Fig. 26B depicts a shape of a cross section of the pixel 12 of Fig. 25 taken along line d-d'. Further, in Fig. 26A, a rectangle indicated by a broken line indicates the position of the vertical gate 141.

By disposing the vertical gates 140, 141, and 142, it is possible to deepen the potential of the region surrounded by these vertical gates in a pseudo manner. Therefore, in a case in which the deep potential region 123 described in Fig. 15 is disposed in the region surrounded by the vertical gates 140, 141, and 142, the efficiency of the transfer (pull-up) of the charge from the region can be improved. Furthermore, the transfer efficiency of the charge from the photoelectric conversion section 101 can be improved in combination with the effect of the electric field having a gradient in the flow path between the vertical gates 140 and 141. The dotted arrow in Fig. 26A indicates the flow path of the charge.

It is to be noted that the drive voltages of the vertical gates 140, 141, and 142 can be applied simultaneously. Further, the drive voltages of the vertical gates 140, 141, and 142 can be applied at different timings. This example will be described with reference to Fig. 27.

### Drive Signal

Fig. 27 is a diagram depicting an example of the driving of the charge transfer section according to the fifth embodiment of the present disclosure. The drawing is a diagram depicting an example of drive signals of the vertical gates 140, 141, and 142 of the charge holding section 103. In the drawing, "vertical gate 140", "vertical gate 141", and "vertical gate 142" represent waveforms of binarized drive signals of the vertical gates 140, 141, and 142, respectively. The H level portions of these waveforms represent the drive voltages.

As depicted in Fig. 27, by shifting the application of the drive voltages to the vertical gates 140, 141, and 142, it is possible to deepen the potential between the vertical gates 140, 141, and 142 as compared with a case in which the drive voltages are applied to the vertical gates 140, 141, and 142 at the same time. This is because the vertical gates 140, 141, and 142 are capacitively coupled to each other, and thus the drive voltages already applied are boosted in accordance with a coupling capacitance every time a voltage is applied to the vertical gates. This makes it possible to improve the transfer efficiency of the charge even in a case in which the potential of the semiconductor region 121 constituting the photoelectric conversion section 101 is deep.

Further, since the vertical gates 140, 141, and 142 are capacitively coupled to the semiconductor region 122 constituting the charge holding section 103, the potential of the charge holding section 103 can be further boosted by shifting the application of the drive voltages to the vertical gates 140, 141, and 142. This makes it possible to improve the transfer efficiency of the charge even in a case in which the potential of the semiconductor region 121 constituting the photoelectric conversion section 101 is deep. Further, by adjusting the timing of application of the drive voltages to the vertical gates 140, 141, and 142, it is possible to adjust the boosting of the charge holding section 103.

Other configurations of the light detection device 1 are similar to the configurations of the light detection device 1 in the first embodiment of the present disclosure, and thus the description thereof will be omitted.

Thus, in the light detection device 1 according to the fifth embodiment of the present disclosure, by disposing the vertical gates 140, 141, and 142, it is possible to improve the transfer efficiency of the charge and improve the light detection characteristics.

### 6. Sixth Embodiment

Variations of the charge transfer section 102 of the fifth embodiment described above will now be described.

### Configuration of Pixel

Figs. 28 to 35 are diagrams depicting configuration examples of the pixel according to the sixth embodiment of the present disclosure. Figs. 28 to 35 are diagrams depicting configuration examples of the pixel 12, similarly to Fig. 25.

Fig. 28 depicts an example of a case of including the vertical gates 140 and 141 configured in shapes in which the facing surfaces are parallel to each other.

Fig. 29 depicts an example of a case of including the vertical gate 142 configured in a rectangular shape in a plan view.

Fig. 30 depicts an example of a case of including the vertical gates 140 and 141 configured in elliptical shapes in a plan view.

Fig. 31 depicts an example of a case of including the vertical gates 140 and 141 configured in elliptical shapes in a plan view and disposed in parallel.

Fig. 32 depicts an example of a case of including the vertical gates 140 and 141 provided such that the flow path of the charge between the vertical gates 140 and 141 is configured at an angle of less than 45 degrees relative to the side of the separation section 170.

Fig. 33 depicts an example of a case of including the vertical gates 140 and 141 of Fig. 32 and including the vertical gate 142 configured in a rectangular shape in a plan view.

Fig. 34 depicts an example of a case of including the vertical gates 140 and 141 provided such that the flow path between the vertical gates 140 and 141, which are configured in elliptical shapes in a plan view, is configured at an angle of less than 45 degrees relative to the side of the separation section 170.

Fig. 35 depicts an example of the flow path between the vertical gates 140 and 141 configured in elliptical shapes in a plan view and disposed in parallel being configured at an angle of less than 45 degrees relative to the side of the separation section 170.

Figs. 36 and 37 are diagrams depicting other configuration examples of the pixel according to the sixth embodiment of the present disclosure. Figs. 36 and 37 are schematic cross-sectional views depicting configuration examples of the pixel 12, similarly to Fig. 26A.

Figs. 36 and 37 each depict an example of a case in which the sizes of the vertical gates 140 and 141 and the vertical gate 142 in the depth direction of the semiconductor substrate 11 differ from each other. Fig. 36 depicts an example in which the vertical gates 140 and 141 are configured to have a size shorter than that of the vertical gate 142 in the depth direction of the semiconductor substrate 11. Further, Fig. 37 depicts an example in which the vertical gates 140 and 141 are configured to have a size longer than that of the vertical gate 142 in the depth direction of the semiconductor substrate 11.

Figs. 38 and 39 are diagrams depicting other configuration examples of the pixel according to the sixth embodiment of the present disclosure. Figs. 38 and 39 are schematic cross-sectional views illustrating configuration examples of the pixel 12, similarly to Fig. 26B.

Fig. 38 depicts an example of a case of including the vertical gates 140 and 141 in which the facing surfaces of the vertical gates 140 and 141 are constituted of inclined surfaces.

Fig. 39 depicts an example of a case in which the vertical gates 140 and 141 are disposed separated from the separation section 170.

Figs. 40 to 45 are diagrams depicting other configuration examples of the pixel according to the sixth embodiment of the present disclosure. Figs. 40 to 45 are diagrams depicting configuration examples of the pixel 12, similarly to Fig. 25. Further, Figs. 40 to 45 are diagrams depicting variations of the plate electrode disposed in the charge transfer section 102.

Fig. 40 depicts an example of a plate electrode 156 connected to the vertical gates 140 and 141.

Figs. 41 to 43 depict examples of the plate electrode 156 connected to the vertical gates 140, 141, and 142.

Figs. 44 and 45 depict examples of cases of including plate electrodes respectively connected to the vertical gates 140, 141, and 142. In Figs. 44 and 45, a plate electrode 155 is connected to the vertical gate 140. A plate electrode 154 is connected to the vertical gate 141. A plate electrode 153 is connected to the vertical gate 142.

Fig. 44 depicts an example of the plate electrodes 153 to 155 configured in planar shapes similar to those of the vertical gates 140, 141, and 142.

Fig. 45 depicts an example of the plate electrodes 153 to 155 configured in rectangular shapes in a plan view.

Fig. 46 is a diagram depicting another configuration example of the pixel according to the sixth embodiment of the present disclosure. The drawing is a schematic cross-sectional view depicting a configuration example of the pixel 12, similarly to Fig. 26B. Further, the drawing depicts an example of the plate electrode 156 connected to the vertical gates 140 and 141. The contact plug 133 is connected to the plate electrode 156.

Other configurations of the light detection device 1 are similar to the configurations of the light detection device 1 in the fifth embodiment of the present disclosure, and thus the description thereof will be omitted.

### 7. Seventh Embodiment

In the light detection device 1 of the first embodiment described above, the vertical gates 140 and 141 are disposed in parallel, and the plane orientations of the surfaces of the semiconductor substrate 11 in contact with the vertical gates 140 and 141 are aligned. In contrast, the light detection device 1 according to a seventh embodiment of the present disclosure differs from that in the first embodiment described above in that the plane orientation of the surface of the semiconductor substrate 11 in contact with the vertical gate 140 and the plane orientation of the surface of the semiconductor substrate 11 in contact with the separation section 170 are aligned.

### Configuration of Pixel

Fig. 47 is a diagram depicting a configuration example of the pixels according to the seventh embodiment of the present disclosure. The drawing, similarly to Fig. 4, is a diagram depicting a configuration example of the pixels 12 disposed in the pixel array section 13. The pixels 12 (pixel 12a, pixel 12b, pixel 12c, and pixel 12d) in the drawing differ from the pixels 12 in Fig. 4 in that the vertical gate 141 is omitted.

Further, the pixels 12 in Fig. 47 further include an embedded electrode (embedded electrode 160) adjacent to the charge holding section 103. This embedded electrode 160 is configured in a shape embedded in the separation section 170 in the central portion of the four pixels (pixel 12a, pixel 12b, pixel 12c, and pixel 12d). The embedded electrode 160 is an electrode formed of, for example, polycrystalline silicon containing impurities and is connected to the semiconductor region 122 constituting the charge holding section 103.

Further, the pixels 12 in Fig. 47 further include the element separation section 173. The pixel transistors can be disposed in the regions separated by this element separation section 173.

The vertical gate 140 is disposed in the pixel 12 of Fig. 47. The vertical gate 140 of Fig. 47 is configured in a rectangular shape in a plan view, and the side surface is configured parallel to the side of the separation section 170. This makes it possible to align the plane orientation of the surface of the semiconductor substrate 11 in contact with the vertical gate 140 and the plane orientation of the surface of the semiconductor substrate 11 in contact with the separation section 170. Here, the side surface of the vertical gate 140 close to the separation section 170 is referred to as a first surface, and a surface facing the first surface is referred to as a second surface. In the vertical gate 140 of Fig. 47, the plane orientation of the surface of the semiconductor substrate 11 in contact with the first surface and the second surface and the plane orientation of the surface of the semiconductor substrate 11 in contact with the separation section 170 are aligned.

Usually, the characteristics of the interface of the semiconductor substrate 11 vary depending on the plane orientation. For example, the (110) plane has many interface states caused by crystal defects. Therefore, in a case in which the (110) plane appears on the surface of the semiconductor substrate 11 in contact with the separation section 170, a dark current, which is a current due to charges caused by the interface state, increases. Further, in a case in which the (110) plane appears on the surface of the semiconductor substrate 11 in contact with the vertical gate 140, the dark current flowing into the charge holding section 103 increases when the charge transfer section 102 is non-conductive. This dark current causes noise relative to the pixel signal generated by the pixel circuit 22. In a case in which the dark current increases, the noise level increases. Then, the level of the pixel signal is relatively low, lowering sensitivity.

Therefore, by aligning the plane orientation of the surface of the semiconductor substrate 11 in contact with the vertical gate 140 and the plane orientation of the surface of the semiconductor substrate 11 in contact with the separation section 170, it is possible to dispose crystal planes having favorable characteristics on both surfaces. For example, the (100) plane can be applied to the plane orientation of the surface of the semiconductor substrate 11. The (100) plane has a small interface state as compared with that of the (110) plane, reducing the dark current caused by the interface state. As a result, the noise level lowers. This makes it possible to prevent a decrease in the sensitivity of the pixel 12.

It is to be noted the plane orientation of the surface of the semiconductor substrate 11 in contact with the side surface of the element separation section 173 can be aligned with the plane orientation of the surface of the semiconductor substrate 11 in contact with the vertical gate 140. That is, the plane orientation of the surface of the semiconductor substrate 11 in contact with one or both of the separation section 170 and the element separation section 173 and the plane orientation of the surface of the semiconductor substrate 11 in contact with the vertical gate 140 can be aligned. Accordingly, a crystal plane having favorable characteristics can be disposed at the surface of the semiconductor substrate 11 in contact with the vertical gate 140, the separation section 170, and the element separation section 173. This makes it possible to reduce the dark current flowing into the photoelectric conversion section 101 and improve the light detection characteristics.

### Configuration of Cross Section of Pixel

Fig. 48 is a diagram depicting a configuration example of the pixel according to the seventh embodiment of the present disclosure. The drawing is a schematic cross-sectional view depicting a configuration example of the pixel 12, similarly to Fig. 5. Further, the drawing is a diagram depicting a configuration of a cross section taken along line e-e' of Fig. 47. The separation section 170 in the drawing is configured to include the first separation section 171 and the second separation section 172. As depicted in the drawing, the first separation section 171 and the second separation section 172 can be configured in shapes in which respective bottom portions come into contact with each other. In this case, it is possible to dispose an insulating member in an opening extending through the semiconductor substrate 11 and improve the performance for separating the pixels 12. It is to be noted that the first separation section 171 may be omitted.

Further, as depicted in Fig. 48, the embedded electrode 160 is configured in a shape embedded in the second separation section 172 adjacent to the corner portion of the pixel 12. The semiconductor region 122 constituting the charge holding section 103 is disposed in the semiconductor substrate 11 adjacent to this embedded electrode 160. This semiconductor region 122 is a semiconductor region formed by the impurities contained in the embedded electrode 160 diffusing into the semiconductor substrate 11. The contact plug 133 is connected to the embedded electrode 160.

Other configurations of the light detection device 1 are similar to the configurations of the light detection device 1 in the first embodiment of the present disclosure, and thus the description thereof will be omitted.

Thus, by aligning the plane orientation of the surface of the semiconductor substrate 11 in contact with the vertical gate 140 and the plane orientation of the surface of the semiconductor substrate 11 in contact with the separation section 170, the light detection device 1 according to the seventh embodiment of the present disclosure can include the pixel 12 having improved light detection characteristics.

### 8. Eighth Embodiment

In the light detection device 1 of the seventh embodiment described above, the vertical gate 140 is disposed in the pixel 12. In contrast, the light detection device 1 according to an eighth embodiment of the present disclosure differs from that of the seventh embodiment described above in that a plurality of the vertical gates are disposed in the pixel 12.

### Configuration of Pixel

Fig. 49 is a diagram depicting a configuration example of the pixels according to the seventh embodiment of the present disclosure. The drawing, similarly to Fig. 47, is a diagram depicting a configuration example of the pixels 12 disposed in the pixel array section 13. The pixels 12 (pixel 12a, pixel 12b, pixel 12c, and pixel 12d) in the drawing differ from the pixels 12 in Fig. 47 in further including the vertical gate 141. It is to be noted that, for convenience, the element separation section 173 and some reference signs are omitted.

The vertical gates 140 and 141 are disposed adjacent to two sides of the separation section 170 close to the charge holding section 103, respectively. The plane orientation of the surface of the semiconductor substrate 11 in contact with the side surface of the vertical gate 140 and the plane orientation of the surface of the semiconductor substrate 11 in contact with the side of the separation section 170 adjacent to the vertical gate 140 are aligned. Similarly, the plane orientation of the surface of the semiconductor substrate 11 in contact with the side surface of the vertical gate 141 and the plane orientation of the surface of the semiconductor substrate 11 in contact with the side of the separation section 170 adjacent to the vertical gate 141 are aligned. The plane orientations of these planes can be the (100) plane. This can prevent a decrease in the sensitivity of the pixel 12. In the vertical gates 140 and 141 of Fig. 49, the plane orientation of the surface of the semiconductor substrate 11 in contact with the second surface and the plane orientation of the surface of the semiconductor substrate 11 in contact with the separation section 170 are aligned.

### Other Configuration of Pixel

Figs. 50 and 51 are diagrams depicting other configuration examples of the pixels according to the seventh embodiment of the present disclosure. Figs. 50 and 51, similarly to Fig. 49, are diagrams depicting configuration examples of the pixels 12 disposed in the pixel array section 13.

Fig. 50 depicts an example of a case in which the vertical gates 140 and 141 are disposed at positions overlapping the separation section 170.

Fig. 51 depicts an example of a case in which part of the vertical gates 140 and 141 are disposed in the separation section 170.

In the pixels 12 in Figs. 50 and 51, at least part of the vertical gates 140 and 141 has a shape that extends across the separation section 170, making it possible to widen a vacant region of the pixel 12. It is to be noted that, in the vertical gates 140 and 141 in Figs. 50 and 51, the plane orientation of the surface of the semiconductor substrate 11 in contact with the second surface and the plane orientation of the surface of the semiconductor substrate 11 in contact with the separation section 170 are aligned.

Other configurations of the light detection device 1 are similar to the configurations of the light detection device 1 in the seventh embodiment of the present disclosure, and thus the description thereof will be omitted.

Thus, the light detection device 1 according to the eighth embodiment of the present disclosure includes the vertical gates 140 and 141, making it possible to improve the transfer efficiency of the charge and improve the light detection characteristics.

### 9. Ninth Embodiment

Variations of the light detection device 1 of the seventh embodiment described above will now be described.

### Configuration of Cross Section of Pixel

Figs. 52 and 53 are diagrams depicting configuration examples of the pixel according to a ninth embodiment of the present disclosure. Figs. 52 and 53, similarly to Fig. 48, are schematic cross-sectional views depicting configuration examples of the pixel 12. In the pixel 12 in Figs. 52 and 53, the configuration of the separation section 170 differs from that of the separation section 170 in Fig. 48.

Fig. 52 depicts an example of a case in which the separation section 170 is configured to include the second separation section 172 and a third separation section 174. The third separation section 174 is a separation section constituted of an insulating member disposed in an opening formed at a depth from the back surface side of the semiconductor substrate 11 to the vicinity of the front surface of the semiconductor substrate 11. This third separation section 174 can be formed of, for example, SiO₂. The third separation section 174 is configured to a depth such that a bottom portion thereof reaches the well region of the semiconductor substrate 11.

It is to be noted that a fixed charge film 175 is disposed between the third separation section 174 and the semiconductor substrate 11 and on the front surface of the semiconductor substrate 11 on the back side. This fixed charge film 175 is, for example, a film that generates a fixed charge having negative polarity. By disposing this fixed charge film 175, it is possible to form an inversion layer in the semiconductor substrate 11 adjacent to the fixed charge film 175. This inversion layer can enhance the pinning of the interface state of the semiconductor substrate 11, and can reduce generation of a dark current caused by the interface state. For example, a film of aluminum oxide (Al₂O₃) can be applied to the fixed charge film 175.

Fig. 53 depicts an example of a case in which an electrode 176 embedded in the first separation section 171 is provided. A bias voltage having negative polarity can be applied to the electrode 176. By applying this bias voltage, it is possible to enhance the pinning at the interface of the semiconductor substrate 11 in contact with the first separation section 171 and reduce generation of a dark current. The electrode 176 can be formed of, for example, polycrystalline silicon containing impurities, aluminum (Al), tungsten (W), platinum (Pt), or the like.

Other configurations of the light detection device 1 are similar to the configurations of the light detection device 1 in the seventh embodiment of the present disclosure, and thus the description thereof will be omitted.

### 10. Configuration of Electronic Device

The light detection device 1 such as described above can be applied to various electronic devices such as, for example, an imaging system such as a digital still camera or a digital video camera, a mobile telephone having an imaging function, or other devices having an imaging function.

Fig. 54 is a block diagram depicting a configuration example of an imaging device mounted on an electronic device. As depicted in Fig. 54, an electronic device 701 includes an optical system 702, a light detection device 703, and a digital signal processor (DSP) 704, is configured by connecting, via a bus 707, the DSP 704, a display device 705, an operation system 706, a memory 708, a recording device 709, and a power supply system 710, and can image a still image and a moving image.

The optical system 702 is configured to include one or a plurality of lenses, guides image light (incident light) from a subject to the light detection device 703, and forms an image on a light-receiving surface (sensor section) of the light detection device 703.

The light detection device 1 of any of the configuration examples described above is applied to the light detection device 703. In the light detection device 703, electrons are accumulated for a certain period of time in accordance with an image formed on the light-receiving surface through the optical system 702. Then, a signal corresponding to the electrons accumulated in the light detection device 703 is input to the DSP 704.

The DSP 704 performs various signal processing on the signal from the light detection device 703 to acquire an image, and temporarily stores the image in the memory 708. The data of the image stored in the memory 708 is recorded in the recording device 709 or supplied to the display device 705 to display the image. Further, the operation system 706 receives various operations by a user and supplies an operation signal to each block of the electronic device 701, and the power supply system 710 supplies power necessary for driving each block of the electronic device 701.

### 11. Application Example of Mobile Body

The technology according to the present disclosure (present technology) can be applied to various products. For example, the technology according to the present disclosure may be realized as a device mounted on any type of mobile body such as an automobile, an electric vehicle, a hybrid electric vehicle, a motorcycle, a bicycle, a personal mobility, an airplane, a drone, a ship, and a robot.

Fig. 55 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in Fig. 55, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 55, an audio speaker 12061, a display section 12062, and an instrument panel 12063 are illustrated as the output device. The display section 12062 may, for example, include at least one of an on-board display and a head-up display.

Fig. 56 is a diagram depicting an example of the installation position of the imaging section 12031.

In Fig. 56, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 56 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour) . Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 among the configurations described above. Specifically, the light detection device 1 in Fig. 1 can be applied to the imaging section 12031.

### 12. Application Example of Endoscopic Surgery System

The technology according to the present disclosure (present technology) can be applied to various products. For example, the technology according to the present disclosure may be applied to an endoscopic surgery system.

Fig. 57 is a view depicting an example of a schematic configuration of an endoscopic surgery system to which the technology according to an embodiment of the present disclosure (present technology) can be applied.

In Fig. 57, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process) .

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

Fig. 58 is a block diagram depicting an example of a functional configuration of the camera head 11102 and the CCU 11201 depicted in Fig. 57.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type) . Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscope surgery system to which the technology according to the present disclosure can be applied has been described above. The technology according to the present disclosure can be applied to the endoscope 11100, the image pickup unit 11402 of the camera head 11102 among the configurations described above. Specifically, the light detection device 1 in Fig. 1 can be applied to the image pickup unit 11402.

It is to be noted that, although the endoscopic surgery system has been described as an example here, the technology according to the present disclosure may be applied to, for example, a microscopic surgery system or the like.

It is to be noted that the semiconductor device of the present disclosure can include a charge transfer section constituted of a MOS transistor that transfers charges from the second semiconductor region to the first semiconductor region. Specifically, in the charge transfer section 102 in Fig. 5, the charge transfer section can be constituted of a MOS transistor that transfers charges from the semiconductor region 122 to the semiconductor region 121.

It is to be noted that the configuration of the fourth embodiment of the present disclosure can be applied to other embodiments. Specifically, the configuration of the vertical gates 140 and 141 having different sizes in Fig. 18 can be applied to the pixels 12 in Fig. 4, Figs. 7 to 14, Fig. 15, Fig. 25, Figs. 28 to 46, and Figs. 49 to 51.

The configuration of the fifth embodiment of the present disclosure can be applied to other embodiments. Specifically, the vertical gate 142 in Fig. 25 can be applied to the pixel 12 in Fig. 4, Figs. 7 to 14 to 17, Fig. 22, Fig. 24, and Figs. 49 to 51.

The configuration of the seventh embodiment of the present disclosure can be applied to other embodiments. Specifically, the configuration of the vertical gate 140 and the separation section 170 in Fig. 47 can be applied to the pixels 12 in Fig. 4, Fig. 7, Fig. 10, Fig. 11, Fig. 14, and Fig. 22.

The configuration of the ninth embodiment of the present disclosure can be applied to other embodiments. Specifically, the configuration of the separation section 170 in Figs. 52 and 53 can be applied to the separation section 170 in the other embodiments.

Although the embodiments of the present disclosure have been described above, the technical scope of the present disclosure is not limited to the above-described embodiments, and various modifications can be made without departing from the gist of the present disclosure. Further, the constituent elements of different embodiments and modifications may be combined as appropriate.

It is to be noted that the effects described in the present specification are merely examples and are not limiting, and other effects may also be present.

It is to be noted that the present technology can also adopt configurations such as the following.
(1) A semiconductor device including:
   a charge transfer section including a MOS transistor including a first semiconductor region disposed in a semiconductor substrate, a second semiconductor region disposed in the vicinity of a front surface of the semiconductor substrate, and a plurality of vertical gates, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other,
   wherein the plurality of vertical gates are disposed in parallel.
(2) The semiconductor device according to (1),
   wherein the plurality of vertical gates are configured to have different sizes.
(3) The semiconductor device according to (1) or (2), further including:
   a pixel including the first semiconductor region, the second semiconductor region, and the charge transfer section; and
   a separation section disposed at a boundary between the pixels,
   wherein the pixel is configured to have a shape of a rectangle in a plan view,
   the second semiconductor region is disposed at a corner portion of the rectangle, and
   the plurality of vertical gates are each disposed at an angle of less than 45 degrees relative to a side of the separation section.
(4) The semiconductor device according to (3), further including:
   a pixel transistor disposed in the pixel and connected to the second semiconductor region.
(5) A semiconductor device including:
   a charge transfer section including a MOS transistor including a first semiconductor region disposed in a semiconductor substrate, a second semiconductor region disposed in the vicinity of a front surface of the semiconductor substrate, and a first vertical gate, a second vertical gate, and a third vertical gate, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other,
   wherein the first vertical gate and the second vertical gate are disposed between the second semiconductor region and the third vertical gate in a plan view.
(6) The semiconductor device according to (5), further including:
   a pixel including the first semiconductor region, the second semiconductor region, and the charge transfer section; and
   a separation section disposed at a boundary between the pixels,
   wherein the pixel is configured to have a shape of a rectangle in a plan view, and
   the second semiconductor region is disposed at a corner portion of the rectangle.
(7) The semiconductor device according to (6),
   wherein the first vertical gate and the second vertical gate are disposed in parallel.
(8) The semiconductor device according to (6),
   wherein the first vertical gate and the second vertical gate are configured such that surfaces facing each other are in parallel.
(9) The semiconductor device according to (8),
   wherein the first vertical gate and the second vertical gate are configured such that the surfaces facing each other form an angle of less than 45 degrees relative to a side of the separation section.
(10) The semiconductor device according to any one of (5) to (9),
   wherein the first vertical gate and the second vertical gate differ in size from the third vertical gate in a thickness direction of the semiconductor substrate.
(11) The semiconductor device according to any one of (5) to (10),
   wherein different drive voltages are applied to the first vertical gate, the second vertical gate, and the third vertical gate.
(12) A semiconductor device including:
   a charge transfer section including a MOS transistor including a first semiconductor region disposed in a semiconductor substrate, a second semiconductor region disposed in the vicinity of a front surface of the semiconductor substrate, and a plurality of vertical gates, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other,
   wherein the plurality of vertical gates are configured to have different sizes.
(13) The semiconductor device according to (12), further including:
   a pixel including the first semiconductor region, the second semiconductor region, and the charge transfer section;
   a pixel transistor disposed in the pixel and connected to the second semiconductor region;
   a separation section disposed at a boundary between the pixels; and
   an element separation section separating the second semiconductor region and the charge transfer section from the pixel transistor,
   wherein the pixel is configured to have a shape of a rectangle in a plan view, and
   the second semiconductor region is disposed at a corner portion of the rectangle.
(14) The semiconductor device according to (13),
   wherein one of the plurality of vertical gates is disposed close to the element separation section and is configured to have a size smaller than a size of the other of the plurality of vertical gates.
(15) The semiconductor device according to (13) or (14), further including:
   a third semiconductor region disposed adjacent to the separation section and configured to have an impurity concentration higher than an impurity concentration of the first semiconductor region,
   wherein one of the plurality of vertical gates is disposed adjacent to the third semiconductor region and is configured to have a size larger than a size of the other of the plurality of vertical gates in a depth direction of the semiconductor substrate.
(16) A semiconductor device including:
   a pixel including a charge transfer section including a MOS transistor including a first semiconductor region disposed in a semiconductor substrate, a second semiconductor region disposed in the vicinity of a front surface of the semiconductor substrate, and a vertical gate, the vertical gate being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other; and
   a separation section,
   wherein the vertical gate includes a side surface in contact with a surface of a semiconductor region having the same orientation plane as an orientation plane of a surface of the semiconductor region in contact with the separation section.
(17) The semiconductor device according to (16),
   wherein the vertical gate includes the side surface in contact with a surface of a semiconductor region having a plane orientation (100).
(18) The semiconductor device according to (16) or (17),
   wherein the charge transfer section includes the MOS transistor including a plurality of the vertical gates.
(19) The semiconductor device according to any one of (16) to (18),
   wherein the vertical gate is disposed at a position where at least part of the vertical gate overlaps the separation section.
(20) The semiconductor device according to any one of (16) to (19), including:
   a plurality of the pixels sharing the second semiconductor region.
(21) The semiconductor device according to (16),
   wherein the separation section is disposed at a boundary between the pixels.
(22) The semiconductor device according to (21),
   wherein the separation section includes an insulating member disposed in an opening formed in the front surface of the semiconductor substrate on a front side.
(23) The semiconductor device according to (21),
   wherein the separation section includes an insulating member disposed in an opening formed in the front surface of the semiconductor substrate on a back side.
(24) The semiconductor device according to (21),
   wherein the separation section includes an insulating member disposed in an opening extending through the semiconductor substrate.
(25) The semiconductor device according to (23), further including:
   an electrode disposed in the separation section and configured to supply a bias voltage.

### Reference Signs List

1, 703 Light detection device
11 Semiconductor substrate
12, 12a, 12b, 12c, 12d Pixel
22 Pixel circuit
101 Photoelectric conversion section
102 Charge transfer section
103 Charge holding section
121, 122, 125 Semiconductor region
140 to 142 Vertical gate
144, 145 Surface
153 to 159 Plate electrode
170 Separation section
171 First separation section
172 Second separation section
174 Third separation section
176 Electrode
11402, 12031, 12101 to 12105 Imaging section

## Claims

1. A semiconductor device comprising:
a charge transfer section including a MOS transistor including a first semiconductor region disposed in a semiconductor substrate, a second semiconductor region disposed in the vicinity of a front surface of the semiconductor substrate, and a plurality of vertical gates, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other,
wherein the plurality of vertical gates are disposed in parallel.

2. The semiconductor device according to claim 1,
wherein the plurality of vertical gates are configured to have different sizes.

3. The semiconductor device according to claim 1, further comprising:
a pixel including the first semiconductor region, the second semiconductor region, and the charge transfer section; and
a separation section disposed at a boundary between the pixels,
wherein the pixel is configured to have a shape of a rectangle in a plan view,
the second semiconductor region is disposed at a corner portion of the rectangle, and
the plurality of vertical gates are each disposed at an angle of less than 45 degrees relative to a side of the separation section.

4. The semiconductor device according to claim 3, further comprising:
a pixel transistor disposed in the pixel and connected to the second semiconductor region.

5. A semiconductor device comprising:
a charge transfer section including a MOS transistor including a first semiconductor region disposed in a semiconductor substrate, a second semiconductor region disposed in the vicinity of a front surface of the semiconductor substrate, and a first vertical gate, a second vertical gate, and a third vertical gate, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other,
wherein the first vertical gate and the second vertical gate are disposed between the second semiconductor region and the third vertical gate in a plan view.

6. The semiconductor device according to claim 5, further comprising:
a pixel including the first semiconductor region, the second semiconductor region, and the charge transfer section; and
a separation section disposed at a boundary between the pixels,
wherein the pixel is configured to have a shape of a rectangle in a plan view, and
the second semiconductor region is disposed at a corner portion of the rectangle.

7. The semiconductor device according to claim 6,
wherein the first vertical gate and the second vertical gate are disposed in parallel.

8. The semiconductor device according to claim 6,
wherein the first vertical gate and the second vertical gate are configured such that surfaces facing each other are in parallel.

9. The semiconductor device according to claim 8,
wherein the first vertical gate and the second vertical gate are configured such that the surfaces facing each other form an angle of less than 45 degrees relative to a side of the separation section.

10. The semiconductor device according to claim 5,
wherein the first vertical gate and the second vertical gate differ in size from the third vertical gate in a thickness direction of the semiconductor substrate.

11. The semiconductor device according to claim 5,
wherein different drive voltages are applied to the first vertical gate, the second vertical gate, and the third vertical gate.

12. A semiconductor device comprising:
a charge transfer section including a MOS transistor including a first semiconductor region disposed in a semiconductor substrate, a second semiconductor region disposed in the vicinity of a front surface of the semiconductor substrate, and a plurality of vertical gates, each being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other,
wherein the plurality of vertical gates are configured to have different sizes.

13. The semiconductor device according to claim 12, further comprising:
a pixel including the first semiconductor region, the second semiconductor region, and the charge transfer section;
a pixel transistor disposed in the pixel and connected to the second semiconductor region;
a separation section disposed at a boundary between the pixels; and
an element separation section separating the second semiconductor region and the charge transfer section from the pixel transistor,
wherein the pixel is configured to have a shape of a rectangle in a plan view, and
the second semiconductor region is disposed at a corner portion of the rectangle.

14. The semiconductor device according to claim 13,
wherein one of the plurality of vertical gates is disposed close to the element separation section and is configured to have a size smaller than a size of the other of the plurality of vertical gates.

15. The semiconductor device according to claim 13, further comprising:
a third semiconductor region disposed adjacent to the separation section and configured to have an impurity concentration higher than an impurity concentration of the first semiconductor region,
wherein one of the plurality of vertical gates is disposed adjacent to the third semiconductor region and is configured to have a size larger than a size of the other of the plurality of vertical gates in a depth direction of the semiconductor substrate.

16. A semiconductor device comprising:
a pixel including a charge transfer section including a MOS transistor including a first semiconductor region disposed in a semiconductor substrate, a second semiconductor region disposed in the vicinity of a front surface of the semiconductor substrate, and a vertical gate, the vertical gate being a gate electrode disposed embedded in the vicinity of the front surface of the semiconductor substrate with a bottom portion formed in the vicinity of the first semiconductor region, the charge transfer section being configured to transfer a charge from one of the first semiconductor region and the second semiconductor region to the other; and
a separation section,
wherein the vertical gate includes a side surface in contact with a surface of a semiconductor region having the same orientation plane as an orientation plane of a surface of the semiconductor region in contact with the separation section.

17. The semiconductor device according to claim 16,
wherein the vertical gate includes the side surface in contact with a surface of a semiconductor region having a plane orientation (100).

18. The semiconductor device according to claim 16,
wherein the charge transfer section includes the MOS transistor including a plurality of the vertical gates.

19. The semiconductor device according to claim 16,
wherein the vertical gate is disposed at a position where at least part of the vertical gate overlaps the separation section.

20. The semiconductor device according to claim 16, comprising:
a plurality of the pixels sharing the second semiconductor region.

21. The semiconductor device according to claim 16,
wherein the separation section is disposed at a boundary between the pixels.

22. The semiconductor device according to claim 21,
wherein the separation section includes an insulating member disposed in an opening formed in the front surface of the semiconductor substrate on a front side.

23. The semiconductor device according to claim 21,
wherein the separation section includes an insulating member disposed in an opening formed in the front surface of the semiconductor substrate on a back side.

24. The semiconductor device according to claim 21,
wherein the separation section includes an insulating member disposed in an opening extending through the semiconductor substrate.

25. The semiconductor device according to claim 23, further comprising:
an electrode disposed in the separation section and configured to supply a bias voltage.
